(19) Europäisches Patentamt
European Patent Office
Office européen des brevets

(11) EP 4 291 587 B1

(12) **EUROPÄISCHE PATENTSCHRIFT**

(45) Veröffentlichungstag und Bekanntmachung des Hinweises auf die Patenterteilung:
**12.11.2025 Patentblatt 2025/46**

(21) Anmeldenummer: **22708503.2**

(22) Anmeldetag: **11.02.2022**

(51) Internationale Patentklassifikation (IPC):
***C08F 220/00*** *(2006.01)* ***C08F 2/50*** *(2006.01)*
***C09D 133/14*** *(2006.01)* ***G03F 7/00*** *(2006.01)*
***G03F 7/027*** *(2006.01)* ***G03F 7/029*** *(2006.01)*
***G03F 7/105*** *(2006.01)* ***G11B 7/245*** *(2006.01)*
*G02B 5/32* *(2006.01)*

(52) Gemeinsame Patentklassifikation (CPC):
**G03F 7/027; C08F 2/50; C08F 220/00; C09D 133/14; G03F 7/0005; G03F 7/001; G03F 7/029; G03F 7/105; G11B 7/245;** G02B 5/32; G03H 2260/12

(86) Internationale Anmeldenummer:
**PCT/EP2022/053415**

(87) Internationale Veröffentlichungsnummer:
**WO 2022/171821 (18.08.2022 Gazette 2022/33)**

(54) **PHOTOPOLYMERISIERBARE HOE-ZUSAMMENSETZUNG**

PHOTOPOLYMERIZABLE HOE COMPOSITION

COMPOSITION HOE PHOTOPOLYMÉRISABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.02.2021 EP 21156669**

(43) Veröffentlichungstag der Anmeldung:
**20.12.2023 Patentblatt 2023/51**

(73) Patentinhaber: **Xetos AG**
**85662 Hohenbrunn (DE)**

(72) Erfinder: **KNOCKE, Frank**
**85560 Ebersberg (DE)**

(74) Vertreter: **Kraus & Lederer PartGmbB**
**Thomas-Wimmer-Ring 15**
**80539 München (DE)**

(56) Entgegenhaltungen:
**WO-A1-2004/104051**
**WO-A1-2017/047547**
**US-A- 6 096 794**
**US-A1- 2010 203 241**
**US-A1- 2016 091 791**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 4 291 587 B1

**Beschreibung**

## Gebiet der Erfindung

Die vorliegende Erfindung bezieht sich auf photopolymerisierbare Zusammensetzungen und daraus hergestellte Elemente sowie deren Verwendung. Die photopolymerisierbaren Zusammensetzungen eignen sich insbesondere als Aufzeichnungsmaterial für optische Elemente mit Brechungsindexmodulation, insbesondere Hologramme.

Es ist eine Vielzahl von Hologrammen wie Reflexionshologramme, Prägehologramme oder Transmissionshologramme oder Volumenhologramme bekannt.

Ein Volumenhologramm wird beispielsweise dadurch hergestellt, indem zwei Lichtwellen gleicher Wellenlänge, auch Objekt- und Referenzstrahl genannt, zur Interferenz gebracht und ein holographisches Aufzeichnungmedium, in der Regel ein photographischer Film, mit dem entstehenden Interferenzmuster, das i.d.R. ein Intensitätsmuster ist, belichtet wird. Der holographische Belichtungsprozess und die Vervielfältigung des Hologramms (Replikation) sind technisch komplexe optische Verfahren, die spezielle anwendungstechnische Kenntnisse erfordern. Methoden zur Erzeugung von Hologrammen und die Theorie sind in der Literatur umfassend beschrieben [Howard M. Smith, "Principles of Holography", Wiley (1969)] [Fred Unterseher, et al. "Holography Handbook: Making Holograms the Easy Way", Ross Books (1982)] [Graham Saxby, "Practical Holography", Inst, of Physics Pub. (2004)].

Bekannte Aufzeichungsmaterialien mit unterschiedlichem Eigenschaftsprofil und Anwendungsgebiet sind: Silberhalogenid-Emulsionen, gehärtete Dichromat-Gelatine, ferroelektrische Kristalle, photochrome und dichroide Materialien sowie Photopolymere [Howard M. Smith, "Principles of Holography", Wiley (1969).]. Für Anwendungen mit hohen Stückzahlen sind solche Materialien von Interesse, die problemlos in den Anlagen zur Hologrammherstellung und -vervielfältigung integriert werden können und die eine einfache holographische Belichtung und Entwicklung ermöglichen. Photopolymere gelten aufgrund ihrer hohen Effizienz, ihrer einfachen Handhabung und ihrer guten Lagerstabilität als besonders bevorzugt. Die bekanntesten Photopolymere stammen von DuPont, z.B. Omnidex HRF 600 [S. M. Schultz, et al. "Volume grating preferential-order focusing waveguide coupler," Opt. Lett., vol. 24, pp. 1708-1710, Dec. 1999.] Omnidex-Materialien gehört zu der Klasse der sich selbstentwickelnden Photopolymerfilme basierend auf radikalischer Polymerisation und Monomerdiffusion (siehe EP 0324480 A2).

Omnidex-Photopolymere wurden im Laufe der Jahre weiterentwickelt, primär mit dem Ziel, den Brechungsindexkontrast zu erhöhen und im Film einen hohen Beugungswirkungsgrad zu erzielen (siehe US 49421 12 A und DE 69032682 T2). Dennoch werden die anwendungstechnisch relevanten Beugungswirkungsgrade von deutlich über 2/3 durch einen hohen Anteil an thermoplastischem Binder erkauft.

Bei der Filmherstellung muss der Binder für die Beschichtung flüssig sein. Dazu wird ein Lösemittel eingesetzt, dessen Abdampfen nach der Beschichtung zu einer starken Abnahme der Schichtdicke führt. Die aufzutragende Nassschicht ist daher entsprechend dem Lösemittelanteil wesentlich dicker als die resultierende Filmschicht. Der Lösemittelanteil beträgt i.d.R. etwa 80%. Um eine volumenholographisch belichtbare Schicht von 20$\mu$m zu erreichen, muss in diesem Fall eine Nassschicht von 100$\mu$m aufgetragen werden. Die erforderliche hohe Dicke der Nassschicht verhindert oder erschwert die Verwendung von bekannten Druckverfahren, wie Flexo- oder Tiefdruck. Beim Siebdruck kann es bei der Verwendung von schnell trocknenden Lösungsmitteln zu einer Verklebung des Netzes kommen.

Der Film kann zudem erst weiter verarbeitet bzw. aufgewickelt werden, wenn das gesamte Lösemittel abgedampft ist. In der Produktion muss daher eine lange Trocknungsstrecke mit einer gesundheits- und umweltgerechten Absaugung, sowie einer staub- und explosionsgeschützter Umgebung aufgebaut werden. Dieser Aufwand führt dazu, dass die Filmherstellung und die holographische Belichtung i.d.R. an getrennten Orten und Zeiten stattfindet.

Bei den binderhaltigen Materialien ist zudem eine thermische Nachbehandlung ("Tempern") des belichteten und UV-fixierten Photopolymeren nötig, um den maximalen Brechungsindexkontrast zu erzielen (siehe DE 68905610 T2). Das Tempern ist ein zusätzlicher zeitaufwendiger Verarbeitungsschritt, der die Hologrammherstellung neben der aufwendigen Filmherstellung verlangsamt, verkompliziert und verteuert und zudem die Wahl der Trägermaterialien auf nicht temperaturempfindliche einschränkt.

Andere Photopolymer-Materialien für die Volumenholographie wurden von Polaroid (siehe US 5759721 A), Fuji Photo Film (siehe EP 1510862 A2), Konica Minolta Medical & Graphic (siehe US 200505891 A1), Dai Nippon Printing (siehe EP 123151 A1), Nippon Paint (siehe EP 21 1615 A2), Nissan Chemical Industries (siehe US 20050068594 A1), Bayer (siehe WO 2010091795 A1), Xetos (siehe WO 2003036389 A1) und InPhase Technologies (siehe US 2002142227 A1) entwickelt. Der Stand der Technik weist Photopolymere aus, die sich durch ihre holographischen Eigenschaften oder ihre Verarbeitung von Omnidex unterscheiden. Der technische Fortschritt wird durch verringerte Sauerstoffempfindlichkeit dokumentiert, reduzierten Materialschrumpf während der Belichtung, angepasste spektrale Empfindlichkeit (Sensitivität), lösemittelfreie Filmherstellung, höheren Beugungswirkungsgrad ohne Tempern und/oder bessere Temperatur- und Lagerstabilität.

Ein neueres und kommerziell erhältliches holographisches Photopolymer ist das von Bayer Materialscience entwickelte "Bayfol HX"-Film. Dieser enthält als Polymermatrix, welche die holographisch belichtbaren Schreibmonomere aufnimmt, keinen thermoplastischen Binder, sondern ein Polyurethan. Das Polyurethan entsteht durch Polyaddition aus einem Polyisocyanat und Polyol Gemisch. Die reaktiven Komponenten werden erst kurz vor der Beschichtung zusammengemischt und härten auf der Trägerfolie aus. Ein hoher Lösemittelanteil wie bei den vorher beschriebenen binderhaltigen Materialien ist zwar nicht vorhanden, aber durch die Aushärtungszeit von bis zu einer Stunde besteht die selbe Problematik, eine genügend lange staubfreie Trocknungs- bzw. Härtungsstrecke in der Beschichtungsanlage zur Verfügung zu stellen.

Wie bei allen kommerziell erhältlichen Photopolymerfilmen kann der Anwender das Trägermaterial nicht frei wählen und selber beschichten, sondern muss den gelieferten Folienaufbau verarbeiten. Neben der Trägerfolie befindet sich noch eine Kaschierfolie auf der lichtempfindlichen Filmschicht, um eine Verklebung und Verschmutzung zu vermeiden. Das Abziehen dieser Folie kann eine statische Aufladung bewirken, die Staubpartikel anzieht. Da der Film zur Belichtung entweder auf Glas oder einem Master auflaminiert werden muss, wo jedes Staubteilchen eine Fehlstelle erzeugt, wird für eine saubere und fehlerlose Verarbeitung eine extrem staubfreie Umgebung benötigt.

Photopolymersysteme, die einen polymeren Binder oder polymere Matrix enthalten, bilden eine im Wesentlichen feste Filmschicht. Im Unterschied dazu sind auch Binder-freie Systeme vorgestellt worden, die bis zur Belichtung im Wesentlichen flüssig sind (siehe z.B. US-Patent 3,993,485 A oder N. Smirnova, Optics in Information Systems, February 2004, S. 9 oder Xetos (siehe WO 2003036389 A1).

Bei den meisten im Wesentlichen festen Monomer-Binder/Matrix-Photopolymeren diffundieren nach der holographischen Laserbelichtung nicht belichtete Schreibmonomere, die sich im Bereich der dunklen Interferenzlinien befanden, in die belichteten polymerisierten Bereiche nach. Dadurch entsteht ein Brechungsindexunterschied dessen räumliche Modulation dem aufzuzeichnenden Interferenzmuster entspricht. Die Diffusion der Schreibmonomere in der festen Matrix benötigt allerdings Zeit. Eine Temperaturerhöhung kann diesen Vorgang beschleunigen. DuPont gibt für das genannte OmniDex®-Material eine Temperzeit von einer Stunde bei 120 °C an. Beim Bayfol HX-Material wird in den Patenanmeldungen (EP 2 372 454 A1 S.13 [0127], EP 2 219 073 A1 S.15 [0102]) eine Wartezeit von 5min angegeben bevor das Material mit UV-Licht endgültig komplett gehärtet wird,

Für viele Produktionsverfahren sind aber möglichst geringe Zeiten bzw. ein möglichst hoher Durchsatz und eine einfache, kostengünstige Prozessführung für die Herstellung der Hologramme gefordert, so dass umständliche und zeitintensive Nachbehandlungen oder Wartezeiten von Nachteil sind.

Aus diesem Grund wurden photopolymerisierbare Zusammensetzungen entwickelt, die eine effektive Brechungsindexmodulation schon während der Laserbelichtung ausbilden und sofort mit UV-Licht fixiert werden können, wie dies in der EP 1 779 196 B1 beschrieben wird. Dort wurden verschiedene Triglyceride, wie z.B. Rizinusöl, verwendet.

Das Rizinusöl ist eine inerte Komponente, die beim Belichten nicht vernetzt. Dadurch kann sie später aus der Schicht raus migrieren. Um dies sicher zu verhindern, wird die Hologrammschicht in der Regel nachträglich mit einer UV-LackSchicht versiegelt.

Wenn der Rizinusölanteil allerdings zu hoch ist, dann kann dies schon während oder kurz nach der Belichtung passieren. Auch führt ein zu hoher Anteil zu einer Trübung. Je höher der Rizinusanteil ist, desto höher muss die Belichtungstemperatur sein, um eine klare Schicht zu gewährleisten. Durch die Erhöhung der Temperatur verringert sich aber die Viskosität der photopolymerisierbaren Zusammensetzung, was sich negativ auf die holographische Belichtbarkeit auswirkt. Es gibt daher eine Obergrenze des Rizinusanteils und der Belichtungstemperatur, welche für eine holographische Belichtung nicht überschritten werden darf.

Neben den Nachteil, dass die belichtete Schicht relativ schnell mit einem UV-Lack versiegelt werden muss, damit es nicht zum Ausschwitzen des Rizinusöls kommt, haben diese photopolymerisierbaren Zusammensetzungen eine relativ hohe Trübung. Die Materialtrübung fällt umso mehr auf, je dicker die Schichten werden und je höher der Triglyceridanteil ist.

Für Sicherheitselemente und Label die auf eine nicht transparente Unterlage appliziert werden, fällt dies nicht so sehr auf. Aber besonders bei holographisch optischen Elementen (HOE's) ist eine ungetrübte Durchsicht wünschenswert und oft auch notwendig, wenn z.B. die Hologramme in Head-Up-Displays oder in Augmented / Mixed Reality Brillen Verwendung finden sollen. Im Gegensatz zu den holographischen Sicherheitselementen, wo sehr dünne Schichten unter 20μm angestrebt werden, können die Schichtdicken bei HOE's wesentlich dicker im Bereich von über 100μm liegen. Dicke Schichten sind hier teilweise sogar erwünscht um Toleranzen von den optischen Bauteilen auszugleichen die mit der Hologrammschicht kombiniert oder verklebt werden sollen. Dicke Schichten sind oft auch notwenig, wenn nur ein sehr schmaler Spektralbereich des Lichtes reflektiert werden soll. Flüssige photopolymerisierbare Zusammensetzungen bilden abhängig von ihrer Viskosität allerdings nur bis zu einer gewissen Schichtdicke hohe Brechungsindexunterschiede aus. Ab einer gewissen Dicke ist einfach die Dynamik der Flüssigkeit und der Schrumpf bei der Aushärtung zu groß, um ein Muster im Bereich der Lichtwellenlänge effektiv und gleichmäßig aufzuzeichnen. Dies gilt besonders bei holographischen Zweistrahl- bzw. Masterbelichtungen. Die großtechnische Herstellung von im wesentlichen festen Filmmaterialien mit Schichtdicken über 20μm ist dagegen sehr aufwendig und wegen der derzeit noch geringen Nachfrage nicht lohnend. Das Bayfol-HX 200 Material von Covestro wird mit einer Schichtdicke von 16μm angeboten. Der Haze-Wert wird mit <2% angegeben (Product Information Sheet-Bayfol HX 200, Edition 2018-03-01).

Neben einem möglichst niedrigen Haze-Wert muss ein holographisches Element, welches für ein Head-Up Display in der Windschutzscheibe eines Autos integriert wird, noch weiteren Ansprüchen genügen. Die Verbundglasscheibe wird bei der Herstellung in einem Autoklaven bis zu 90min lang Temperaturen in der Höhe von 140°C und Drücken von 12 bar ausgesetzt (WO 03033583 A1). Dies muss das holographische Material und das enthaltene Hologramm ebenfalls unbeschadet ohne Qualitätseinbußen überstehen.

Der Beugungswirkungsgrad (BWG) $\eta$ von Volumenhologrammen hängt von deren Schichtdicke d und vom $\Delta n$ ab. $\Delta n$ bezeichnet die Amplitude der Brechungsindexmodulation innerhalb der Hologrammschicht. Nach der Coupled Wave Theorie von Kogelnik (siehe; H. Kogelnik, The Bell System Technical Journal, Volume 48, November 1969, Number 9 Seite 2909 - Seite 2947) gilt, dass je höher der $\Delta n$-Wert ist, desto dünner können die Schichten sein um ein hohen BWG-Wert zu erreichen. Für Reflexionshologramme von Oberflächenspiegeln bzw. Lippmann-Bragg-Hologramme, wo die Brechungsindexmodulation parallel zur Oberfläche verläuft, gilt folgender Zusammenhang

$$\eta = tanh^2(\frac{\pi \cdot \Delta n \cdot d}{\lambda}), \qquad \text{(F-1)}$$

wobei $\lambda$ die Wellenlänge des Lichtes ist. Für dicke Schichten kann der $\Delta n$-Wert der holographischen Aufzeichnungsmaterialien daher niedriger sein, als für dünne Schichten, um den gleichen Beugungswirkungsgrad zu erreichen.

Mit der photopolymerisierbaren Zusammensetzung können sowohl Transmissions- wie auch Reflexionshologramme aufgezeichnet werden. Die erreichbare Amplitude der Brechungsindexmodulation $\Delta n$ bei den Lippmann-Bragg Hologrammen mit einer Schichtdicke von über 100$\mu$m, deren Gitterlinien parallel zur Oberfläche verlaufen, ist dabei größer als 0,001, bevorzugt größer als 0,002 und besonders bevorzugt größer als 0,003.

Anhand der im Spektrometer bei senkrechter Durchleuchtung gemessenen Wellenlänge $\lambda$ vom Absorptionspeak, dem Beugungswikungsgrad $\eta$ (BWG) und der Schichtdicke d kann $\Delta n$ für diese Hologramme wie folgt berechnet werden.

$$\Delta n = \frac{\lambda}{\pi \cdot d} \cdot arctanh(\sqrt{\eta}), \quad \text{(F-2)}$$

## Beschreibung der Erfindung

Der vorliegenden Erfindung liegt somit die Aufgabe zugrunde, eine photopolymerisierbare Zusammensetzung bereitzustellen, das die genannten Nachteile bekannter Aufzeichnungsmaterialien vermeidet und das vorteilhafterweise holographische Belichten von dicken Schichten über 20$\mu$m, bevorzugt über 50$\mu$m und besonders bevorzugt über 100$\mu$m ermöglicht. Ebenso wie bei dem aus der Anmeldung EP1779196B1 bekannten flüssigen Holographiematerial soll eine sehr schnelle für die Massenproduktion taugliche Verarbeitung möglich sein. Die aus photopolymerisierbare Zusammensetzung hergestellten holographischen Elemente sollten außerdem eine hohe Langzeitstabilität als auch eine thermische und mechanische Stabilität aufweisen. Zudem sollte eine zusätzliche Versiegelung nicht unbedingt notwendig sein. Besonders bevorzugt sollte das gehärtete Material und das darin aufgezeichnete Hologramm den Autoklavenprozess zur Herstellung einer Verbundglasscheibe unbeschadet überstehen. Vorzugsweise soll die photopolymerisierbare Zusammensetzung für Verfahren einsetzbar sein, bei denen Drücke über 5 bar und Temperaturen über 100°C und besonders bevorzugt Drücke über 10 bar und Temperaturen über 120°C auf die photopolymisierbare Zusammensetzung oder daraus hergestellte Elemente einwirken.

Überraschenderweise wurde gefunden, dass die inerten Komponenten wie das Rizinusöl in der EP 1 779 196 B1 beschriebenen Formulierung vorteilhaft durch geeignete aliphatische Urethanacrylate, welche bei der Belichtung ebenfalls vernetzen und daher nicht ausschwitzen können, ersetzt werden kann.

Die Aufgabe wird somit erfindungsgemäß gelöst durch eine photopolymerisierbare Zusammensetzung, die durch UV/VIS-Bestrahlung härtbar ist, umfassend:

a) 25 bis 74,9 Gew.-% mindestens eines Monomers M, umfassend mindestens eine ethylenisch ungesättigte Gruppe oder eines Monomergemisches, umfassend mindestens zwei Monomere M, umfassend unterschiedliche ethylenisch ungesättigte Gruppen, wobei das Monomer M ausgewählt ist aus der Gruppe, bestehend aus (Meth)acrylsäurebutylester, (Meth)acrylsäurephenylester, (Meth)acrylsäurebenzylester, (Meth)acrylsäureisobornylester, (Meth)acrylsäurecyclohexylester, (Meth)acrylsäure-2-phenoxyethylester, (Meth)acrylsäure-1 H,1 H,2H,2H-perfluoroctylester, 2,2,2-Trifluorethyl(meth)acrylat, Heptafluorpro-pyl(meth)acrylat, 1,1,1,3,3,3-Hexyfluorisopropyl(meth) acrylat, 2,2,3,3-Tetrafluorpropyl(meth)acrylat), 2,2,3,3,4,4,4-Heptafluorbutyl(meth)acrylat, 2,2,3,3,4,4,5,5-Octafluorpentyl(meth)acrylat, AcrylsäureN,N-diethylaminoethylester, Acrylsäureethoxyethyoxyethylester, Acrylsäure-2-(p-chlorphenoxy)ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, Hydrochinonmonomethacrylat und 2-[β-(N-Carbazolyl)propionyloxy]ethylacrylat, und außerdem ein Bisphenol A diacrylat mit einem Anteil von über 25 Gew.-% enthält, bezogen auf das Gesamtgewicht der Komponente a),

b) 25 bis 74,9 Gew.-% eines aliphatischen Urethanacrylates oder eines Gemisches aus verschiedenen aliphatischen Urethanacrylaten,

c) 0,1 bis 10 Gew.-% eines Photoinitiators, der die Polymerisation der Monomere und Urethanacrylate bei der Einwirkung aktinischer Strahlung aktiviert;

d) 0,01 bis 20 Gew.-% Additive,

wobei die photopolymerisierbare Zusammensetzung bei einem Standarddruck im Bereich von 15°C bis 150°C flüssig ist.

Angaben in Gew.-% beziehen sind, soweit nicht anders angegeben, auf das Gesamtgewicht der photopolymerisierbaren Zusammensetzung.

Weitere bevorzugte Ausführungsformen sind in den Unteransprüchen definiert. Unter Aktinität (aktinischer Strahlung) kann man die photochemische Wirksamkeit von elektromagnetischer Strahlung unterschiedlicher Wellenlänge verstehen.

Der Begriff wird zum Beispiel bei der Bewertung der physiologischen Folgen von Laserlicht unterschiedlicher Farbe oder der spektralen Empfindlichkeit von fotografischen Filmen und Fotopapieren benutzt. In der Photochemie werden als aktinische Chemikalien solche bezeichnet, die licht- bzw. strahlungsempfindlich sind.

Die Komponente a) enthält ein Bisphenol A Diacrylat mit einem Anteil innerhalb dieser Komponente von über 25 Gew.-%, bevorzugt von über 50 Gew.-% und besonders bevorzugt von über 90 Gew.-%, bezogen auf das Gesamtgewicht der Komponente a).

Besonders bevorzugt als Komponente b) ist ein aliphatisches Urethanediacrylat Harz, insbesondere Ebecryl 230 von der Fa. Allnex, oder ein difunktionelles aliphatisches Urethanediacrylat Harz, insbesondereCN9002 von Sartomer.

Vorzugsweise hat das aliphatische Urethanacrylat oder das Urethanacrylatgemisch eine wesentlich langsamere Vernetzungsgeschwindigkeit als das Monomer oder Monomergemisch. Bei der holographischen Belichtung wird die langsam reagierende Komponente aus den hellen Bereichen des Interferenzmusters verdrängt. Diese Entmischung führt dazu, dass an den dunklen Stellen des Interferenzmusters der Urethanacrylatanteil höher als in den hellen Bereichen ist. Da das Urethanacrylat oder Urethanacrylatgemisch einen anderen Brechungsindex als das Monomer oder Monomergemisch hat, wird der Brechungsindex in der Schicht entsprechend des Interferenzmusters moduliert und ein Hologramm erstellt. Der Unterschied zwischen den Brechungsindizes der beiden Komponenten sollte bei 20°C mindestens 0,02, bevorzugt mindestens 0,05 und besonders bevorzugt mindestens 0,07 sein. Vorzugsweise beträgt der Unterschied zwischen den Brechungsindizes der Komponente a) und der Komponente b) bei 20°C mindestens 0,02.

Der Brechungsindex kann mit einem Refraktometer, z.B. mit einem analogen Abbe-Refraktometer, gemessen werden.

Das Abbe-Refraktometer ist ein optisches Gerät zur Bestimmung der Brechzahl n von Flüssigkeiten. Das Messprinzip beruht auf die Bestimmung des Grenzwinkels zur Totalreflexion. Dazu wird die Flüssigkeit zwischen zwei Glasprismen eingeschlossen und standardmäßig bei einer Temperatur von 20°C mit Licht einer Wellenlänge von 589nm (Natrium-D-Linie) durchleuchtet. Nach Einstellung des Grenzwinkels kann der Brechungsindex auf einer Skala abgelesen werden.

Vorzugsweise kann es sich bei den Urethanacrylaten um Reaktionsprodukte von (Meth)acrylsäuren, Polyolen und mehrfunktionellen Isocyanaten handeln.

Urethanacrylate werden beispielsweise aus (Meth)acrylolylgruppen aufweisenden Alkoholen und Di- oder Polyisocyanaten hergestellt. Herstellverfahren für Urethanacrylate sind grundsätzlich bekannt und beschrieben z. B.in der DE-A-1 644 798, DE-A 2 115 373 oder DE-A-2 737 406. Unter (Meth)acrylolylgruppen aufweisenden Alkoholen sind sowohl eine freie Hydroxylgruppe aufweisende Ester der Acrylsäure oder Methacrylsäure mit zweiwertigen Alkoholen zu verstehen wie beispielsweise 2-Hydroxyethyl-, 2- oder 3-Hydroxypropyl oder 2-, 3-, 4-, Hydroxybutyl-(meth) acrylat als auch beliebige Gemische derartiger Verbindungen. Außerdem kommen auch einwertige (Meth)acryloylgruppen aufweisende Alkohole oder im Wesentlichen aus derartigen Alkoholen bestehende Umsetzungsprodukte in Betracht, die durch Veresterung von n-wertigen Alkoholen mit (Meth)acrylsäure, die durch Veresterung von n-wertigen Alkoholen mit (Meth)acrylsäure und ggf. weiteren Dicarbonsäuren erhalten werden, wobei als Alkohole auch Gemische von unterschiedlichen Alkoholen eingesetzt werden können, so dass n für eine ganze oder im statistischen Mittel gebrochene Zahl von größer 2 bis 4, vorzugsweise 3 steht und wobei pro Mol der genannten Alkohole insbesondere bevorzugt n-1 Mol (Meth)acrylsäure eingesetzt werden.

Überraschenderweise zeigte sich, dass die Klarheit der belichteten Schicht davon abhängt mit welcher Belichtungszeit und -intensität belichtet bzw. gehärtet wird. Wird die Schicht mit ausreichender Intensität schnell unter 1s belichtet, so ist die Schicht weniger trüb, als wenn mit schwächeren Leistungen längere Zeit mehrere Sekunden lang

belichtet wird. Die Trübheit (engl. Haze) ist messbar und wird als Haze-Wert in Prozent angegeben. Die Differenz zwischen den schnell und langsam belichteten Gebieten sollte bei einer Belichtungstemperatur von 21°C und einer Schichtdicke von 1mm, gemessen nach dem ASTM D 1003 Standardverfahren, mindestens 50%, bevorzugt mindestens 60% und besonders bevorzugt mindestens 70% erreichen. Auch die Temperatur hat einen Einfluss auf die Trübheit. Je niedriger die Temperatur ist, desto milchiger wird das Ergebnis. Die Belichtung verschiedener Bereiche bei unterschiedlichen Temperaturen kann somit ebenfalls einen Unterschied bewirken oder den intensitätsabhängigen Effekt noch verstärken.

Die Empfindlichkeit der photopolymerisierbaren Zusammensetzung sollte besser als 150mJ/$cm^2$, bevorzugt besser als 100mJ/$cm^2$ und besonders bevorzugt besser als 50mJ/$cm^2$ sein.

Die Empfindlichkeit gibt die mindest erforderliche Belichtungsdosis für die Erstellung eines Hologrammes an. Dabei muss der Laser die passende Wellenlänge für die verwendeten Farbstoffe im Initiatorsystem haben. Bei der Verwendung eines roten Lasers mit einer Wellenlänge von 633nm wird z.B. Methylenblau und für einen grünen Laser mit 532nm Safranin-O verwendet. Die Laserwellenlänge sollte in der Nähe des spektralen Absorptionsmaximums des entsprechenden Farbstoffes liegen. Die Empfindlichkeit kann durch den Vergleich der belichteten Hologramme ermittelt werden. Sobald bei gleicher Schichtdicke der gemessene Beugungswirkungsgrad sich durch die Erhöhung der Belichtungsdosis nicht mehr verbessern lässt, wurde die erforderliche Mindestdosis erreicht oder überschritten.

Vorzugsweise wird bei der erfindungsgemäßen Zusammensetzung nach dem Auftragen auf ein Substrat oder einer Kopiervorlage keine Zeit für das Abdampfen von flüchtigen Lösungsmittel, für chemische Reaktionen oder thermische Behandlungen benötigt. Es kann sofort nach dem Auftragen der Zusammensetzung auf ein Substrat oder einer Kopiervorlage belichtet werden. Der Nassauftrag der Zusammensetzung auf das Trägermaterial kann durch Rakeln, Doctor Blade oder Schlitzdüsen (Slot-Dye Coating) erfolgen. Für dünne Schichten kleiner 20$\mu$m können auch bekannte Druckverfahren, wie Sieb-, Tief-, Gravur-, Tampon- oder Flexodruck verwendet werden. Bevorzugt wird die photopolymerisierbare Zusammensetzung mit einer transparenten und klaren Folie direkt auf die zu kopierende Vorlage (Master) laminiert. Die Schichtdicke wird entweder durch den Anpressdruck und der Laminiergeschwindigkeit oder über die Schlitzbreite eingestellt. Bei der Beschichtung von dicken und starren Trägern wie z.B. Glasplatten kann ein Spin Coating Verfahren verwendet werden. Auch das Auftragen mit einem Tintenstrahldruckverfahren oder mit einer CNC gesteuerten Dosiervorrichtungen ist möglich. Das direkte Einspritzen in Hohlräumen ist ebenfalls möglich.

Insbesondere eignet sich die photopolymerisierbare Zusammensetzung auch für den Auftrag auf gekrümmten Oberflächen. Es kann auch zwischen zwei zueinander passenden Körpern eingepresst und gleichzeitig als Kit oder Kleber verwendet werden.

Der Anwender hat außerdem die freie Wahl, welche Trägermaterialien und Schichtaufbauten er verwenden möchte, da die Beschichtung in der Belichtungsanlage erfolgt. Die im Wesentlichen von flüchtigen organischen Lösungsmittel freie photopolymerisierbare Zusammensetzung, die davon bevorzugt weniger als 5 Gew.-%, mehr bevorzugt höchstens 1 Gew.-% enthält, kann sofort nach dem Auftrag belichtet werden. Mehrschichtige Belichtungen sind ebenfalls kein Problem, da nach der Härtung nach den selben Prinzip eine neue Schicht aufgetragen und holographisch belichtet werden kann. Dies kann z.B. dazu genutzt werden, um echtfarbige Hologramme aus drei Schichten für die Grundfarben Rot, Grün und Blau aufzubauen.

Bevorzugt werden aliphatische Urethanacrylate mit einer relativ langsamen Reaktionsgeschwindigkeit und einer hohen Flexibilität. Die Flexibilität der gehärteten Schicht ist hilfreich, um das belichtete Hologramm von starren Oberflächen wie Glas oder Metall zu entfernen. Die leichte und saubere Ablösung ist für die Massenproduktion sehr günstig, weil somit verschleißfrei Kopiermaster, wie herkömmliche Nickelshims mit einer feinen holographischen Oberflächenstruktur oder mit Dünnglas versiegelte Volumenhologramme für die Anfertigung von Kontaktkopien verwendet werden können. Durch die restlose Entfernung der nicht klebrigen Schicht bleibt der Reinigungsaufwand gering.

Die photopolymerisierbare Zusammensetzung ist besonders für die Anfertigung von Kontaktkopien geeignet. Dadurch, dass die flüssige photopolymerisierbare Zusammensetzung direkt auf das Master aufgedruckt wird, entfällt das Indexmatching. Darunter wird das Auftragen einer Flüssigkeit zwischen Master und Hologrammschicht mit ungefähr dem gleichen Brechungsindex der beiden Schichten verstanden. Das Indexmatching verhindert beim normalen Kontaktkopierverfahren mit Filmmaterialien das Auftreten von störenden Interferenzerscheinungen (Newtonringe). Diese entstehen durch Reflexionen, die besonders an den Stellen auftreten, wo sich die beiden Schichten z.B. wegen eines Staubeinschlusses oder einer kleinen Unebenheit nicht direkt berühren und es zu Blasen bzw. Lufteinschlüssen kommt. Zudem verbessert der Ausgleich von Kratzern und anderen Unebenheiten vom Trägermaterial und Master die optische Qualität der Kopie. Kleine Staubteilchen mit einer geringeren Abmessung als die Schichtdicke werden in der Flüssigkeit eingebettet und erzeugen keine deutlichen Druck- und Fehlstellen wie bei den Filmmaterialien. Dies verringert den Ausschuss und die Reinraumansprüche an die Produktionsumgebung wesentlich.

Vorteilhaft kann die flüssige photopolymerisierbare Zusammensetzung somit auch als Indexmatch-Material für die Belichtung von holographischen Filmmaterialien eingesetzt werden. Dadurch, dass es beim Belichten aushärtet entfällt die Reinigung oder das Abdampfen. Zudem wird die holographische Aufzeichnung durch die Kombination der beiden holographischen Aufzeichnungsmaterialien unterstützt und verstärkt, da in beiden Schichten ein Hologramm

entsteht.

Weil sich das Flüssigmaterial jeder Oberfläche anpasst, können im Gegensatz zu den Filmmaterialien neben der Hologrammbelichtung gleichzeitig auch Oberflächenstrukturen abgeformt und komplex geformte Oberflächen verwendet werden. Die Oberflächenstrukturen können insbesondere Prägehologramme oder Fresnelstrukturen sein. Dadurch ist es möglich, in einem einzelnen Verarbeitungsschritt sowohl die Oberflächenstruktur als auch die volumenholographische oder optische Information des Masters physikalisch und holographisch zu kopieren.

Auf dieser Weise lassen sich auch optische Elemente wie Prismen oder Linsen mit integrierten Hologrammstrukturen herstellen.

Dadurch, dass die photopolymerisierbare Zusammensetzung nach dem Auftragen sofort belichtet werden kann, sind kompakte Beschichtungs- und Belichtungszeiten mit sehr kurzen Transportwegen und Zeiten zwischen diesen zwei Stationen realisierbar. Somit sinkt die Gefahr einer ungewollten Vorbelichten durch Umgebungslicht. Die Anforderung an einer dunklen Umgebung sind daher nicht groß. Die photopolymerisierbare Zusammensetzung kann innerhalb von 1min, bevorzugt innerhalb von 20s, besonders bevorzugt innerhalb von 5s aufgetragen und belichtet werden.

Die Erfindung betrifft ein Verfahren, bei dem die erfindungsgemäße photopolymerisierbare Zusammensetzung innerhalb einer Minute aufgetragen und belichtet wird.

Die erfindungsgemäße photopolymerisierbare Zusammensetzung umfasst mindestens ein Monomer M, umfassend mindestens eine ethylenisch ungesättigte Gruppe, vorzugsweise ein Monomer M, umfassend mindestens zwei ethylenisch ungesättigte Gruppen.

Besonders bevorzugt umfasst die photopolymerisierbare Zusammensetzung mindestens ein Monomer M, umfassend mindestens eine ethylenisch ungesättigte Gruppe, und ein Monomer M1, umfassend mindestens zwei ethylenisch ungesättigte Gruppen, wobei sich M1 vorzugsweise von M nur durch die zweite ethylenisch ungesättigte Gruppe unterscheidet.

Dabei kann das Monomer, umfassend mindestens eine ethylenisch ungesättigte Gruppe, nachfolgende allgemeine Struktureinheiten aufweisen.

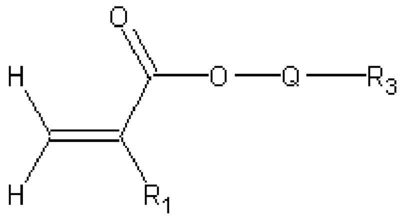

Acrylate

oder

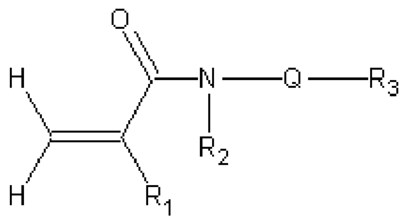

Acrylamide

oder

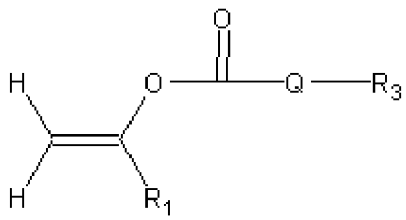

Vinylester

oder

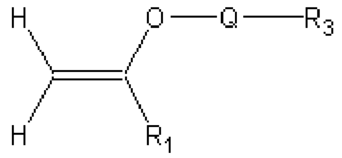

Vinylether

oder

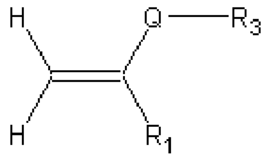

vinylische

oder

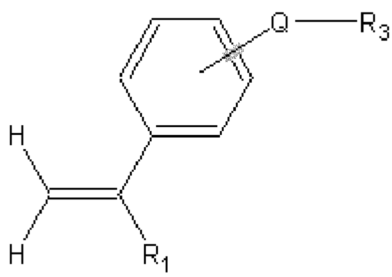

Styrole

wobei

Q= 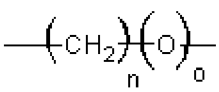 oder 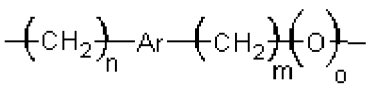

wobei n, m = 0-12, vorzugsweise 1-12; o = 0, 1; und Ar ein ein- oder mehrkerniger substituierter oder unsubstituierter aromatischer oder heterocyclischer aromatischer Rest ist,

wobei der Rest $R_1$ H, Methyl oder Ethyl ist und

wobei die Reste $R_2$ und $R_3$ unabhängig voneinander ausgewählt sind aus der Gruppe bestehend aus Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatischaromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

Beispiele für geeignete Monomere M sind substituierte oder unsubstituierte Styrolmonomere, Acrylsäure, α-Alkylacrylsäure, Acrylsäureester, α-Alkylacrylsäureester, deren Alkoholkomponente ein substituierter oder unsubstituierter aliphatischer oder aromatischer Rest mit 2-50 Kohlenstoffatomen sein kann, Acrylamide, α-Alkylacrylamide, wobei Alkyl die vorstehend angegebene Bedeutung hat, Vinylester, Vinylalkohol, Vinylether und sonstige substituierte vinylische Monomere, substituiert mit substituierten oder unsubstituierten aliphatischen oder aromatischen Resten mit 2-50 Kohlenstoffatomen.

Monomere M sind ausgewählt aus der Gruppe, bestehend aus (Meth)acrylsäurebutylester, (Meth)acrylsäurephenylester, (Meth)acrylsäurebenzylester, (Meth)acrylsäureisobornylester, (Meth)acrylsäurecyclohexylester, (Meth)acrylsäure-2-phenoxyethylester, (Meth)acrylsäure-1H,1H,2H,2H-perfluoroctylester, 2,2,2-Trifluorethyl(meth)acrylat, Heptafluorpropyl(meth)acrylat, 1,1,1,3,3,3-Hexyfluorisopropyl(meth)acrylat, 2,2,3,3-Tetrafluorpropyl(meth)acrylat), 2,2,3,3,4,4,4-Heptafluorbutyl(meth)acrylat, 2,2,3,3,4,4,5,5-Octafluorpentyl(meth)acrylat, AcrylsäureN,N-diethylaminoethylester, Acrylsäureethoxyethyoxyethylester, Acrylsäure-2-(p-chlorphenoxy)ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, 2-(1-Naphthyloxy) ethylacrylat, Hydrochinonmonomethacrylat und 2-[β-(N-Carbazolyl)propionyloxy]ethylacrylat.

Besonders bevorzugte Monomere M sind N-Vinylcarbazol, Ethoxyethoxyethylacrylat, Phenolethoxylatacrylat, 2-(p-Chlorphenoxy)ethylacrylat, p-Chlorphenylacrylat, Phenylacrylat, 2-Phenylethylacrylat, 2-(1-Naphthyloxy)ethylacrylat, t-Butylacrylat, Isobornylacrylat, Cyclohexylacrylat, N,N-Diethylaminoethylacrylat, Ethoxyethoxyethylacrylat, 1H,1H,2H,2H-Perfluoroctlmethacrlat.

Vorzugsweise umfasst das Monomer M mindestens zwei ethylenisch ungesättigte Gruppen, daher ist das Monomer bevorzugt difunktionell.

Difunktionelle ethylenisch ungesättigte Monomere weisen zwei C-C-Doppelbindungen im Molekül auf, d.h. sie enthalten z.B. zwei der voranstehend angegebenen Struktureinheiten. Ein difuntionlles ethylenisch ungesättigtes Monomer kann z.B. zwei Acrylat- oder Methacrylatgruppen enthalten.

Das Monomer M in der erfindungsgemäßen photopolymerisierbaren Zusammensetzung kann ausschließlich aus einem oder mehreren difunktionellen oder höher funktionellen Monomer bestehen, d.h. die Zusammensetzung kann frei von monofunktionellen ethylenisch ungesättigten Monomeren sein. Bevorzugt beträgt der Gehalt an Monomeren M mit mindestens zwei ethylenisch ungesättigten Gruppen in der erfindungsgemäßen Zusammensetzung mehr als 10 Gew.-%, bevorzugt mehr als 20 Gew.-%, und besonders bevorzugt mehr als 30 Gew.-%, bezogen auf das Gesamtgewicht der Zusammensetzung.

Die Verwendung von difunktionellen oder höher funktionellen Monomeren führt insbesondere zu einer besonders hohen thermischen und mechanischen Stabilität der hergestellten holographischen Elemente und ist insbesondere bei der Herstellung von Refexionshologrammen vorteilhaft.

Bevorzugte Bisphenol-A-Diacrylate sind ethoxylierte Bisphenol-A-Diacrylate, insbesondere Verbindungen der folgenden Formel

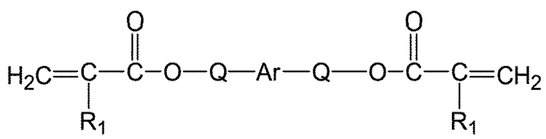

worin $R_1$, Q und Ar die oben angegebene Bedeutung haben.

Ein besonders bevorzugtes Monomer M ist die Verbindung der folgenden Strukturformel:

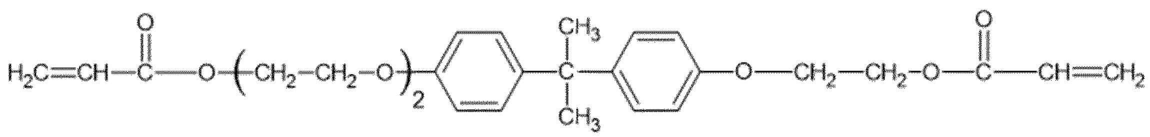

Bevorzugt beträgt die Viskosität des Monomers M bzw. Monomergemisches bei Raumtemperatur mindestens 900 mPa·s.

Die erfindungsgemäße photopolymerisierbare Zusammensetzung umfasst ein aliphatische Urethanacrylat oder ein Gemisch aus verschiedenen aliphatischen Urethanacrylaten.

Die geeigneten Urethanacrylate sind allgemein Verbindungen der folgenden allgemeinen Strukturformel:

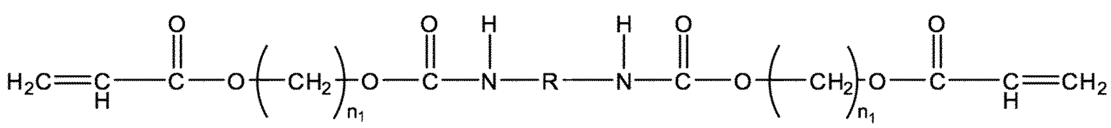

wobei R ein langes Polyol-Segment und NHCOO die Urethanverbindung ist. Ein besonders bevorzugtes aliphatisches Urethanacrylat ist das kommerziell erhältliche Produkt Ebecryl 230 der Firma Allnex und das CN 9002 von Sartomer; und $n_1$ = 0-1000, vorzugsweise 0-100, besonders bevorzugt 1-12.

Das Urethanacrylatgemisch enthält von einem dieser Produkte 25%, bevorzugt über 50% oder besteht besonders bevorzugt nur aus einem von diesen beiden Produkten.

Die Viskosität der photopolymerisierbaren Zusammensetzung beträgt bei 20°C mindestens 2000mPa s, bevorzugt 10000mPa s und besonders bevorzugt mindestens 20000mPa s.

Die Viskosität kann mit einem Platte-Platte-Rotationsrheometer (z.B. von der Fa. Haake, Typ 006-2805) bestimmt werden. Dabei befindet sich das Material zwischen zwei koaxialen, kreisrunden Platten von denen eine rotiert.

Die Platten haben z.B. einen Abstand von 1mm und einen Durchmesser von 35mm. Aus der Messung des Drehmomentes und der Drehzahl (z.B. 10 Umdrehungen/s) kann die Viskosität ermittelt werden (DIN53018, ISO3210).

Die erfindungsgemäße photopolymerisierbare Zusammensetzung umfasst mindestens einen Photoinitiator, der vorzugsweise die Polymerisation des oder der Monomeren M und des oder der aliphatischen Uretanacrylaten bei der Einwirkung (aktinischer) Strahlung aktiviert. Dabei handelt es sich vorzugsweise um einen radikalbildenden Polymerisationsinitiator.

Radikalbildende Polymerisationsintitiatoren sind bekannt, vgl. z.B. Timpe, H.J. und S. Neuenfeld, "Dyes in photoinitiator systems", Kontakte (1990), Seiten 28-35 und Jakubiak, J. und J.F. Rabek, "Photoinitiators for visible light polymisation", Polimery (Warschau) (1999), 44, Seiten 447-461.

Zu den geeigneten radikalbildenden Polymerisationsinitiatoren, die durch UV-Strahlung aktivierbar und im allgemeinen bei Temperaturen bis zu 185°C inaktiv sind, gehören die substituierten oder unsubstituierten mehrkernigen Chinone; dabei handelt es sich um Verbindungen mit zwei intracyclischen Kohlenstoff-Atomen in einem konjugierten carbocyclischen Ringsystem, z.B. 9,10-Anthrachinon, 1-Chloranthrachinon, 2-Chloranthrachinon, 2-Methylanthrachinon, 2-Ethylanthrachinon, 2-tert-Butylanthrachinon, Octamethylanthrachinon, 1,4-Naphthochinon, 9,10-Phenanthrenchinon, 1,2-Benzanthrachinon, 2,3-Benzanthrachinon, 2-Methyl-1,4-naphthochinon, 2,3-Dichlornaphthochinon, 1,4-Dimethylanthrachinon, 2,3-Dimethylanthrachinon, 2-Phenylanthrachinon, 2,3-Diphenylanthrachinon, Natrium-Salz von Anthrachinon-α-sulfonsäure, 3-Chlor-2-methylanthrachinon, Retenchinon, 7,8,9,10-Tetrahydronaphthacenchinon und 1,2,3,4-Tetrahydrobenz[a]anthracen-7,12-dion. Weitere Photoinitiatoren, die ebenfalls brauchbar sind, wenn auch manche bei so niedrigen Temperaturen wie 85°C thermisch aktiv sind, sind in US-Patent 2 760 663 beschrieben, und zu ihnen zählen vicinale Ketaldonylalkohole wie etwa Benzoin, Pivaloin, Acyloinether, z.B. Benzoinmethyl- und -ethylether, α-Kohlenwasserstoff-substituierte aromatische Acyloine, darunter α-Methylbenzoin, α-Allylbenzoin und α-Phenylbenzoin.

Als Photoinitiator verwendbar sind photoreduzierbare Farbstoffe und Reduktionsmittel wie etwa die in den US-Patenten 2 850 445, 2 875 047, 3 097 096, 3 074 974, 3 097 097, 3 145 104 und 3 579 339 offenbarten, sowie Farbstoffe aus der Klasse der Phenazine, Oxazine und Chinone; Michlers Keton, Benzophenon, 2,4,5-Triphenylimidazolyl-Dimere mit Wasserstoff-Donoren und deren Mischungen, wie beschrieben in den US-Patenten 3 427 161, 3 479 185, 3 549 367, 4 311 783, 4 622 286 und 3 784 557. Eine brauchbare Diskussion der farbstoffsensibilisierten Photopolymerisation findet sich in "Dye Sensitized Photopolymerization" von D.F: Eaton in Adv. in Photochemistry, Bd. 13, D.H. Volman, G.S. Hammond und K. Gollnick, Hrsg., Wiley-Interscience, New York, 1986, S. 427-487. In gleicher Weise sind auch die Cyclohexadienon-Verbindungen von US-Patent Nr. 4 341 860 als Initiatoren brauchbar. Zu den geeigneten Photoinitiatoren gehören CDM-HABI, d.h., 2-(o-Chlorphenyl)-4,5-bis(m-methoxyphenyl)-imidazol-Dimer; o-Cl-HABI, d.h., 2,2'-Bis(o-chlorphenyl)-4,4',5,5'-tetraphenyl-1,1'-biimidazol; und TCTM-HABI, d.h., 2,5-Bis(o-chlorphenyl)-4-(3,4-dimethoxyphenyl)-1H-imidazol-Dimer, die jeweils typischerweise mit einem Wasserstoff-Donor verwendet werden, z.B. 2-Mercaptobenzoxazol.

Besonders bevorzugte UV-Photoinitiatoren sind IRGACURE® OXE-01 (1,2-Octandion-1-[4-(phenylthio)-phenyl]-2-(O-benzoyloxim) und IRGACURE® OXE-02 (1-[9-Ethyl-6-(2-methylbenzoyl)-9H-carbazol-3-yl]ethanon-O-acetyloxim von der der BASF AG, sowie OMNIRAD-MBF (Methylbenzoylformiat), OMNIRAD-TPO (2,4,6-Trimethylbenzoyl-diphenyl-phosphinoxid), OMNIRAD-TPO-L (Ethyl-(2,4,6-trimethylbenzoyl)-phenylphosphinat), OMNIRAD-1173 (2-Hydroxy-2-methyl-1-phenylpropanon), OMNIRAD 1000 (Mischung aus 2-Hydroxy-2-methyl-1-phenylpropanon (80%) und 1-Hydroxycyclohexyl-phenylketon (20%)), OMNIRAD 184 (1-Hydroxycyclohexyl-phenylketon), OMNIRAD 819 (Bis(2,4,6-trimethylbenzoyl)phenylphosphinoxid), OMNIRAD 2022 (Mischung aus 2-Hydroxy-2-methyl-1-phenylpropanon, Bis(2,4,6-trimethylbenzoyl)phenylphosphinoxid und Ethyl(2,4,6-trimethylbenzoyl)-phenylphosphinat) und OMNICAT 440 (4,4'-Dimethyl-diphenyl-iodonium-hexafluorphosphat), die von IGM Resins erhältlich sind und bevorzugt in einer Menge von 0,1 bis 10 Gew.-% eingesetzt werden.

| | | | |
|---|---|---|---|
| 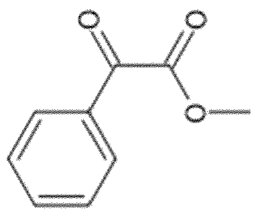 | OMNIRAD MBF | 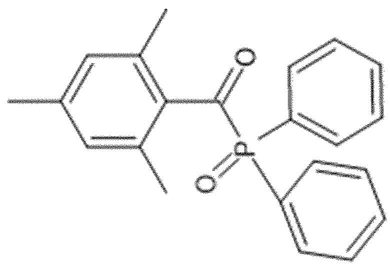 | OMNIRAD TPO |
| | | 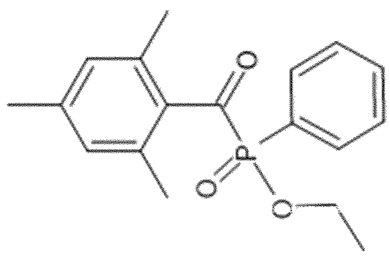 | OMNIRAD TPO-L |
| 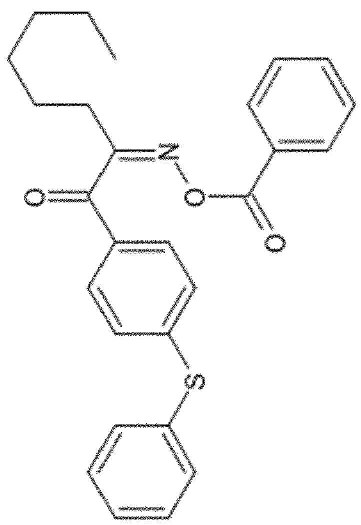 | IRCACURE® OXE-01 | 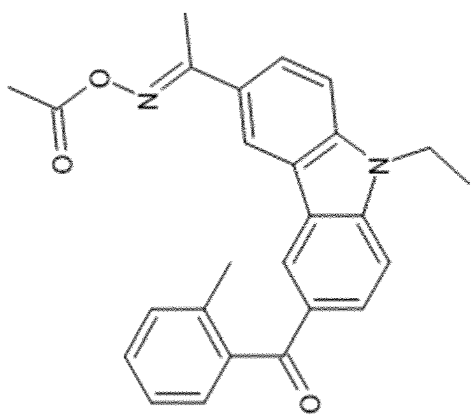 | IRGACURE® OXE-02 |

(fortgesetzt)

| | | |
|---|---|---|
| 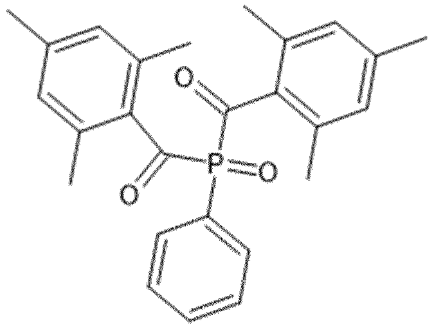 | 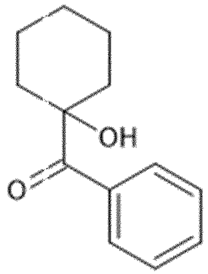 | 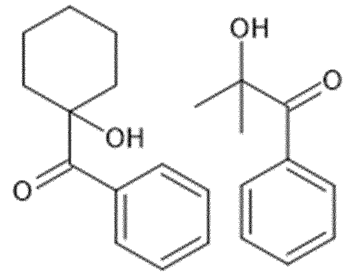 |
| **OMNIRAD 819** | **OMNIRAD 184** | **OMNIRAD 1000** |
| 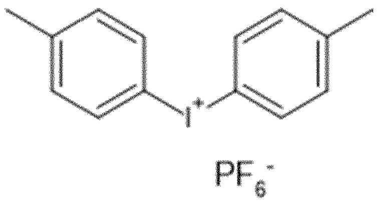 | 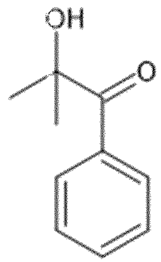 | |
| **OMNICAT 440** | **OMNIRAD 1173** | |
| 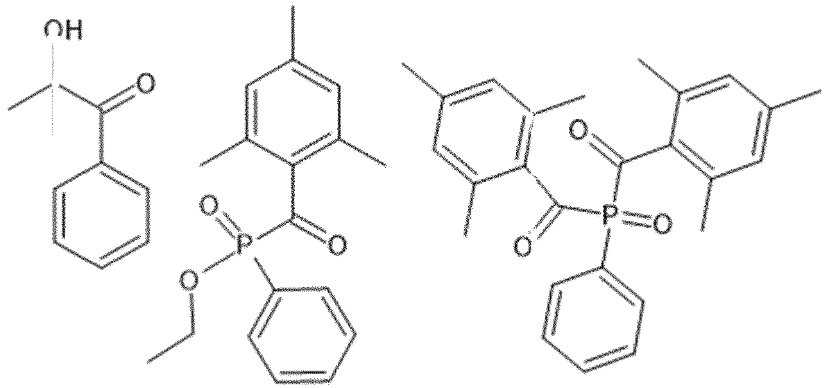 | | |
| **OMNIRAD 2022** | | |

Die voranstehend genannten Photoinitiatoren können alleine oder in Kombination eingesetzt werden.

Vorzugsweise enthält der Photoinitiator einen Farbstoff und als Coinitiator bzw. Co-Photoinitiator ein Boratsalz. Die Begriffe "Coinitiator" und "Co-Photoinitiator" werden im Rahmen der vorliegenden Erfindung austauschbar verwendet.

Ein besonders bevorzugter Photoinitiator umfasst die Verbindung der folgenden Strukturformel I (Co-Photoinitiator) und Farbstoffe (Sensibilisierungsmittel), wie z.B. Methylenblau, und die in den US-Patenten 3 554 753 A, 3 563 750 A, 3 563 751 A, 3 647 467 A, 3 652 275 A, 4 162 162 A, 4 268 667 A, 4 454 218 A, 4 535 052 A und 4 565 769 A offenbarten Sensibilisierungsmittel, sowie die in der Anmeldung WO 2012062655 A2 genannten Farbstoffe und Co-Photoinitiatoren, auf die hierin ausdrücklich Bezug genommen wird. Zu den besonders bevorzugten Sensibilisierungsmitteln gehören die folgenden: DBC, d.h., 2,5-Bis[(4-diethylamino-2-methylphenyl)methylen]cyclopentanon; DEAW, d.h., 2,5-Bis[(4-diethylaminophenyl)methylen]cyclopentanon; Dimethoxy-JDI, d.h., 2,3-Dihydro-5,6-dimethoxy-2-[(2,3,6,7-tetrahydro-1H,5H-benzo[i,j]chinolizin-9-yl)methylen]-1H-in-den-1-on; und Safranin O, d.h., 3,7-Diamino-2,8-dimethyl-5-phenyl-phenazinium-chlorid.

Die Verbindung mit der Strukturformel I, die unter der Bezeichnung "CGI 7460" von Ciba Specialty Chemicals Inc. entwickelt wurde und nun unter dem Namen SEC LCA 1460 bei der BASF AG erhältlich ist, wird wie folgt dargestellt:

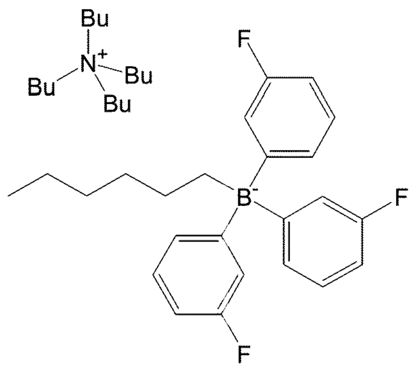

(I)

Besonders bevorzugt können die Farbstoffe als Farbstoffkonzentrate (siehe Tabelle 2 und 3) in einer Mischung ohne flüchtige Lösungsmittel zur Verfügung gestellt werden. Dies vereinfacht die Zubereitung der photopolymerisierbaren Zusammensetzungen, da auf ein Auskochen der flüchtigen Substanzen verzichtet und auch einfacher und genauer dosiert werden kann.

Vorzugsweise ist der Farbstoff in den erfindungsgemäßen photopolymerisierbaren Zusammensetzungen ausgewählt aus der Gruppe, bestehend aus Acriflavinen, Diaminoacridinen, Rhodamin B, Safranin-O, Diethylsafranin und Methylenblau.

Vorzugsweise ist der Co-Photoinitiator in dem erfindungsgemäßen photopolymerisierbaren Zusammensetzungen ausgewählt aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

Das Photoinitiatorsystem, das die Polymerisation der Monomere und Urethanacrylate bei der Einwirkung aktinischer Strahlung aktiviert, besteht aus einem Photoinitiator oder einem Co-Photoinitiator und einem Farbstoff. Bevorzugt enthält es alle drei genannten Komponenten.

Zur Anpassung an das gewählte Verarbeitungsverfahren oder das Einsatzgebiet der photopolymerisierbaren Zusammensetzung und zur Verbesserung der Druckbarkeit, Oberflächenhaftung, Viskosität, Filmbildung, Flexibilität, Härte, Kälte-, Hitze- und Witterungsbeständigkeit kann die Zusammensetzung verschiedene an sich bekannte Additive enthalten.

Daher umfasst die photopolymerisierbare Zusammensetzung ein Additiv.

Die Additive umfassen dabei Lösungsmittel, Füllsubstanzen, Farbstoffe, Weichmacher, Tenside, übliche Komponenten, die in Photopolymersystemen verwendet werden, polymere Binder, Netzmittel, Verlaufsmittel, Entschäumer, Haftvermittler, Oberflächenadditive, nanoskalige Teilchen, optische Aufheller oder Mischungen daraus.

Diese sollen sich gut einmischen lassen und den Beugungswirkungsgrad nicht verschlechtern. Nicht flüchtige Substanzen können den Beugungswirkungsgrad bei dünnen Schichten sogar noch dauerhaft verbessern, indem insbesondere solche Additive gewählt werden, die den Brechungsindexunterschied zwischen dem ethylenisch ungesättigten Monomer und den übrigen Komponenten der photopolymerisierbaren Zusammensetzung erhöhen. Wenn die Urethankomponente einen niedrigeren Brechungsindex als die Komponente des ethylenisch ungesättigten Monomers besitzt, so sollte das Additive bzw. sollten die Additive ebenfalls einen möglichst niedrigen Brechungsindex besitzen. Daher kommen in diesem Fall neben bekannten Polymeren mit einem niedrigen Brechungsindex wie Polyvinylacetat

besonders fluorierte oder silanisierte Polymere in Betracht. Um gute Diffusionseigenschaften zu erreichen, sollte das Molekulargewicht der in Betracht gezogenen Additive nicht zu hoch sein.

Die voranstehend erwähnten und nachfolgend im Einzelnen angegebenen Additive werden in einer Menge von 0,01 bis 20 Gew.-%, bevorzugt 0,01 bis 10 Gew.-%, eingesetzt, bezogen auf das Gesamtgewicht der Zusammensetzung.

Die photopolymerisierbare Zusammensetzung kann einen Weichmacher enthalten, um die Modulation des Brechungsindex der mit Bild versehenen Zusammensetzung zu verstärken. Weichmacher können in Mengen eingesetzt werden, die von etwa 0,01 bis etwa 10 Gew.-% reichen, vorzugsweise 5 bis etwa 10 Gew.-%, bezogen auf das Gesamtgewicht der Zusammensetzung. Zu den geeigneten Weichmachern gehören Triethylenglycol, Triethylenglycoldiacetat, Triethylenglycoldipropionat, Triethylenglycoldicaprylat, Triethylenglycoldimethylether, Triethy-lenglycolbis(2-ethylhexanoat), Tetraethylenglycoldiheptanoat, Polyethylenglycol, Polyethylenglycolmethylether, Isopropylnaphthalin, Diisopropylnaphthalin, Polypropylenglycol, Glyceryltributyrat, Diethyladipat, Diethylsebacinat, Dibutylsuberinat, Tributylphosphat, Tris(2-ethylhexyl)phosphat, Brij® 30 [$C_{12}H_{25}(OCH_2CH_2)_4OH$], Brij® 35 [$C_{12}H_{25}(OCH_2CH_2)_{20}OH$], sowie n-Butylacetat. Besonders bevorzugte Weichmacher sind Polyethylenglycol, Triethylenglykol-diethylhexanoat (3G8), Triethylenglycoldicaprylat, Tetraethylenglycoldiheptanoat, Diethyladipat, Brij® 30 und Tris(2-ethylhexyl)phosphat.

Falls gewünscht, können andere übliche Komponenten, die in PhotopolymerSystemen verwendet werden, mit den Zusammensetzungen und Elementen dieser Erfindung eingesetzt werden. Zu diesen Komponenten gehören: Optische Aufheller, ultraviolette Strahlung absorbierendes Material, thermische Stabilisatoren, Wasserstoff-Donoren, Sauerstoff-Fänger und Trennmittel. Diese Additive können auch Polymere oder Co-Polymere umfassen.

Zu den brauchbaren optischen Aufhellern gehören die im US-Patent 3 854 950 A offenbarten. Ein bevorzugter optischer Aufheller ist 7-(4'-Chlor-6'-diethylamino-1',3',5'-triazin-4'-yl)amino-3-phenylcumarin. Auch ultraviolette Strahlung absorbierende Materialien, die für diese Erfindung brauchbar sind, sind im US-Patent 3 854 950 A offenbart.

Zu den brauchbaren thermischen Stabilisatoren gehören: Hydrochinon, Phenidon, p-Methoxyphenol, Alkyl- und Aryl-substituierte Hydrochinone und Chinone, tert-Butylcatechin, Pyrogallol, Kupferresinat, Naphthylamine, β-Naphthol, Kupfer(I)-chlorid, 2,6-Di-tert-butyl-p-cresol, Phenothiazin, Pyridin, Nitrobenzol, Dinitrobenzol, p-Toluchinon und Chloranil. Brauchbar sind auch die in US-Patent 4 168 982 A beschriebenen Dinitroso-Dimere. Normalerweise ist auch ein Inhibitor für die thermische Polymerisation vorhanden, um die Stabilität bei der Lagerung der photopolymerisierbaren Zusammensetzung zu erhöhen.

Zu den als Kettenübertragungsreagenzien brauchbaren Wasserstoff-Donorverbindungen gehören: 2-Mercaptobenzoxazol, 2-Mercaptobenzothioazol etc. sowie verschiedene Arten von Verbindungen, z.B. (a) Ether, (b) Ester, (c) Alkohole, (d) Verbindungen, die allylischen oder benzylischen Wasserstoff enthalten wie etwa Cumol, (e) Acetale, (f) Aldehyde, und (g) Amide, wie offenbart in Spalte 12, Zeilen 18 bis 58 in US-Patent 3 390 996 A, auf die hierin ausdrücklich Bezug genommen wird.

Verbindungen, die sich als Trennmittel brauchbar erwiesen haben, sind beschrieben in US-Patent 4 326 010 A. Ein bevorzugtes Trennmittel ist Polycaprolacton.

Die photopolymerisierbare Zusammensetzung kann auch einen oder mehrere polymere Binder enthalten, der bzw. die ausgewählt ist aus der Gruppe umfassend Polymethylmethacrylat und Polyethylmethacrylat, Polyvinylester, wie Polyvinylacetat, Polyvinylacetat/-acrylat, Polyvinylacetat/-methacrylat und teilweise hydrolisiertes Polyvinylacetat, Ethylen/Vinylacetat-Copolymere, Vinylchlorid/Carbonsäurester-Copolymere, Vinylchlorid/Acrylsäureester-Copolymere, Polyvinylbutyral und Polyvinylformal, Butadien und Isoprenpolymere und Copolymere und Polyethylenoxide aus Polyglycolen mit einem durchschnittlichen Molekulargewicht von etwa 1.000 bis 1.000.000 g/mol, Epoxide, wie Acrylat- oder Methacrylatreste enthaltende Epoxide, Polystyrole, Celluloseester, wie Celluloseacetat, Celluloseacetatsuccinat und Celluloseacetatbutyrat, Celluloseether, wie Methylcellulose und Ethylcellulose, Polykondensate, wie Polycarbonate, Polyester, Polyamide, wie N-Methoxymethylpolyhexamethylenadipamid, Polyimide, Polyurethane. Die genannten polymeren Binder können z.B. in einer Menge von 0,001 bis 10 Gew.-%, bezogen auf das Gesamtgewicht der Zusammensetzung, eingesetzt werden.

Die photopolymerisierbare Zusammensetzung kann auch ein oder mehrere Netzmittel (insbesondere Fluor-Carbonpolymere, wie zum Beispiel Schwego-Fluor 8038™, oder Fluorotenside, wie zum Beispiel 3M Fluorad FC-4430™), Verlaufsmittel (insbesondere Glykolsäure-n-butylester oder Polyether-modifizierte Polydimethylsiloxane, wie zum Beispiel ADDID 130™), Entschäumer (insbesondere Entschäumer auf Fluorsilikonölbasis, wie zum Beispiel ADDID 763™), Haftvermittler (insbesondere Diamino-Trimethoxy-funktionelle Silanhaftvermittler, wie zum Beispiel ADDID 900™ oder Glycidyl-Trimethoxytrifunktionelle Silanhaftvermittler, wie zum Beispiel ADDID 911™, Vinyltriethyoxysilan oder 3-Methacryloxypropyltrimethoxysilan), oder Oberflächenadditive (insbesondere Polyether-modifizierte acrylfunktionelle Polydimethylsiloxane, wie zum Beispiel BYK-UV 3500™, Polyether-modifizierte Polydimethylsiloxane, wie zum Beispiel BYK-UV 3510™ oder Polyether-modifizierte acrylfunktionelle Polydimethylsiloxane, wie zum Beispiel BYK-UV 3530™) enthalten. Die genannten Produkte mit den Handelsnahmen "ADDID" bzw. "BYK" sind von Wacker bzw. BYK Chemie erhältlich.

Die photopolymerisierbare Zusammensetzung kann auch nanoskalige Teilchen wie z.B. $TiO_2$, $SiO_2$ oder Au enthalten, die ggf. an Monomere gekoppelt sein können (solche Materialien sind z.B. unter der Handelsbezeichnung

"Nanocryl" erhältlich).

Vorzugsweise kann das Additiv ein Aminsynergist sein. Ein Aminsynergist kann in Kombination mit anderen Photoinitiatoren die Aushärtungsgeschwindigkeit von UV-Lacken erhöhen (siehe DE60216490T2).

Vorzugsweise kann das Additiv ein Peroxid sein. Ein thermisch aktivierbarer Peroxid kann in Kombination mit anderen Photoinitiatoren die Aushärtung von UV-Lacken besonders in Schattenbereichen verbessern (siehe US 5017406 A oder DE 60030223 T2).

Vorzugsweise kann das Additiv auch ein Marker ausgewählt aus Fluoreszenzpigmenten oder Lanthanidverbindungen sein. Als Lanthanidverbindungen können beispielsweise Europium oder Terbium Trisdipicolinat Komplexe verwendet werden.

Unter einem Marker wird im Sinne der vorliegenden Erfindung eine forensisch nachweisbare Substanz verstanden, über die die Authentizität oder die Herkunft eines Produktes bzw. dessen Produzent oder Verkäufer ermittelt werden kann. Vorausgesetzt, dass die zu erzeugenden Schichten dick genug sind um die entsprechenden Mikropartikel einzubetten, können auch kleine individualisierte Partikel, buntes Mikroplastik auch Taggant genannt, eingebracht werden

Vorzugsweise ist die photopolymerisierbare Zusammensetzung bei Standarddruck in einem Bereich von 20°C bis 150°C, ganz besonders bevorzugt 25°C bis 120°C flüssig.

In einer weiteren Ausgestaltung umfasst die Erfindung ein Element, enthaltend eine Komponente, die erhältlich ist durch Einwirkung von (aktinischer) UV/VIS-Strahlung auf die erfindungsgemäße photopolymerisierbare Zusammensetzung.

Vorzugsweise umfasst das erfindungsgemäße Element eine Komponente, die transparente und/oder transluzente Bereiche aufweist.

Wird die photopolymerisierbare Zusammensetzung in einem Zeitraum von mindestens 1s bis 5 min, vorzugsweise von 2s bis 2 min mit einer Lichtquelle von höchstens 50 $mW/cm^2$ belichtet, kann sie milchig werden. Es entsteht eine Mattscheibe, deren Streueigenschaften durch die gewählte Belichtungsmethode (Dauer, Intensität, Temperatur, etc.) gezielt und lokal verändert werden kann. Auch macht es einen Unterschied, ob mit kohärentem Laserlicht (Speckles) oder weißem bzw. UV-Licht belichtet wird. Durch die Specklegröße kann z.B. gezielt die Körnigkeit eingestellt werden. Die erreichbare Auflösung ist sehr hoch. Daher können vorzugsweise Komponenten bereitgestellt werden, die transparente und/oder transluzente Bereiche umfassen.

Mit einer Maskenbelichtung können so beliebige Strukturen, Texte und Bilder erzeugt werden, die unabhängig von einer holographischen Wiedergabe über ihre Mattheit zu erkennen sind.

In einer weiteren Ausführungsform betrifft die Erfindung die Verwendung des erfindungsgemäßen Elements als Folie, Linse, Gitter, Prisma, Spiegel, Strahlteiler, Diffusor, Oberflächenrelief, optischer Schalter oder Sensor.

Durch die Belichtung mit einem gerichteten Strahl und einem Strichmuster können milchige Lamellen, die senkrecht oder schräg im regelmäßigen Abstand in der Schicht stehen, belichtet werden um eine Jalousiefolie zu erzeugen. Diese Folie ist in einer Richtung, die dem Belichtungswinkel entspricht, transparent und ansonsten milchig. So eine Folie kann z.B. als Blickschutzfolie für Bildschirme verwendet werden.

Das Ganze kann zudem mit holographischen Eigenschaften kombiniert werden, indem die noch nicht belichteten Bereiche schnell und transparent holographisch belichtet werden. Die entstandene Folie reagiert dann z.B. auf einen bestimmten Beleuchtungswinkel. Strahlumlenkung und Streuung kann aufeinander abgestimmt werden. Auch die Verwendung von mehreren Schichten die nacheinander aufgetragen und unterschiedlich belichtet werden ist denkbar.

Hinzukommt, dass gleichzeitig eine Oberfläche z.B. eine Linsenstruktur abgeformt werden kann. So ist es möglich, Strukturen zu erzeugen, die z.B. das Licht von einem LED-Array bündeln und als gerichteten Lichtstrahl und anderes Licht, von LED's die sich nicht im Linsenraster befinden, als Streulicht wiedergeben. Diese Streuung kann durch die matten Bereiche außerhalb der Linsenstrahlengänge verstärkt werden. Die Verwendung eine Bienenwabenstruktur mit matten Wänden wäre eine mögliche Ausführungsform.

Eine Anwendung wären Lichtquellen, die den natürlichen Himmel imitieren und direktes gerichtetes weißgelbes Sonnenlicht sowie blaues Streulicht abgeben. Das LED-Array dieses künstlichen "Dachfensters" könnte natürlich noch die Helligkeit und Farbe wie bei einem Bildschirm lokal variieren, so dass unterschiedliche Lichtstimmungen, Tageszeiten, bewölkter Himmel, und vorbeiziehende Wolken simuliert werden könnten.

Das blaue Licht könnte auch durch ein Reflexionshologramm aus den gerichteten Weißlichtstrahl gefiltert und auf die Streuzentren oder -flächen gelenkt werden. All dies, Abformung, Lichtbündelung, Streuung und Hologramm kann mit der photopolymerisierbaren Zusammensetzung in einem Belichtungsvorgang realisiert oder durch wiederholtes Auftragen und Belichten in mehreren Schichten kombiniert werden.

Auch beim Automobil wird gerichtetes und gestreutes Licht benötigt. Gerichtetes Licht für die Scheinwerfer, die die Straße ausleuchten und gestreutes Licht, wie bei Blinker, Brems- oder Rückleuchten, die für die anderen Verkehrsteilnehmer in einem großen Winkelbereich erkennbar sein sollen. Durch den Einsatz der oben beschriebenen und erklärten Spezialfolie, könnte z.B. ein Scheinwerfer so konstruiert werden, dass er über seine komplette Fläche ebenso auch die Funktion eines Blinkers erfüllt. Der Scheinwerfer würde gleichzeitig das gerichtete Scheinwerferlicht und wenn

nötig in allen Richtungen gestreutes gelbes Licht abgeben können.

Besonders bevorzugt ist ein erfindungsgemäßes Element, umfassend ein Hologramm, das erhältlich ist durch die Einwirkung einer holographische Information tragenden, modulierenden Strahlung auf die erfindungsgemäße photopolymerisierbare Zusammensetzung.

Die Herstellung der Hologramme erfolgt im allgemeinen, indem eine holographische Information tragende modulierte Strahlung auf eine Schicht der photopolymerisierbaren Zusammensetzung, die auf einem Träger-Substrat oder einer Kopiervorlage aufgebracht ist, einwirken lässt. Als Träger-Substrate für die Hertstellung der erfindungsgemäßen Elemente können Glas, Kunststoff, insbesondere PET, PP, PMMA, Polycarbonat oder Cellulose-Di bzw. Triacetat, oder Papier verwendet werden. Bei der Belichtung kann sich die photopolymersierbare Zusammensetzung z.B. zwischen zwei Glasplatten befinden.

Die Erfindung betrifft Verfahren zur Herstellung eines erfindungsgemäßen Elements oder der erfindungsgemäßen photopolymerisierbaren Zusammensetzung, bei denen das Element oder die Zusammensetzung einer Temperatur von mehr als 100°C und einem Druck von mehr als 2 bar ausgesetzt ist.

Die Erfindung betrifft weiterhin ein Verfahren zur Bildung eines lichtbeständigen Hologramms in einer photopolymerisierbaren Schicht auf einer Substratoberfläche oder Kopiervorlage, umfassend die Einwirkung einer eine holographische Information tragenden, modulierten Strahlung auf eine Schicht einer erfindungsgemäßen photopolymerisierbaren Zusammensetzung.

Besonders bevorzugt ist ein Element, umfassend ein Hologramm, wobei das Hologramm mit einem Quellstoff behandelt wird. Ein Quellstoff im Sinne der vorliegenden Erfindung ist ein Stoff der mittels Diffusion ein Quellen des Hologramms und bei Reflexionshologrammen eine spektrale Verschiebung des reflektierten Lichtes zu einer höheren Wellenlänge bewirkt.

Ein grünes Reflexionshologramm kann z.B. so in ein Rotes verwandelt werden.

Die gleiche Methodik ist auch mit dem Blitzlicht verwendbar. Aufgebrachte Stoffe verdampfen und dringen blitzschnell in die Schicht ein. Dies funktioniert erstaunlicherweise auch dann, wenn die Photopolymerschicht schon von einer UV-Lack Schicht versiegelt ist.

Dies kann wunderbar dazu genutzt werden, um ein fertiges Hologramm nachträglich zu individualisieren. Der Quellstoff wird dazu zum Beispiel mit einem gängigen Tintenstrahldruckverfahren aufgebracht. Durch den nachträglichen starken UV-Blitz, verdampfen die wirksamen Substanzen und erzeugen durch das Eindringen dort wo sie aufgebracht worden sind eine Quellung und lokale Farbänderungen im Hologramm. Die eingebrachte Information kann z.B. ein Bild, eine Nummer oder eine Beschriftung sein. Da diese Änderungen nicht rückgängig gemacht werden können und nur das Hologramm beeinflussen, ist dieses schnelle und einfache Verfahren eine gute Möglichkeit die Fälschungssicherheit von Ausweisen, Siegeln oder Vignetten zu erhöhen. Besonders bei den Produkten, die am Ausgabeort noch individualisiert werden und wo dies einfach durchführbar sein muss.

Anstatt eines Tintenstrahldruckers und eines Blitzes kann auch ein Thermosublimationsdrucker verwendet werden, der die Quellstoffe über ein entsprechendes Druckerband verdampft.

Bei dicken Schichten kann ein Konzentrationsgefälle entstehen. Das eingedrungene Material quellt dann die obere Schicht stärker als die tiefen Schichten. Dies führt im Absorptionsspektrum zu einer Verbreiterung des Absorptionspeaks. Auch ein Doppelpeak ist möglich, wenn der Quellbereich abrupt endet und die Stärke der Quellung nicht allmählich abnimmt.

Eine Verbreiterung des Peaks besagt, dass ein größerer Wellenlängenbereich reflektiert wird und auch der Wiedergabewinkel für eine bestimmte Wellenlänge breiter wird. Die Möglichkeit diese wichtigen Parameter eines Hologramms nachträglich ändern zu können ist für viele technische Anwendungen nutzbar. z.B. für HUD's die auch unter einen größeren Wiedergabe- bzw. Betrachtungswinkel funktionieren sollen.

Die Hologrammschicht kann auch mit einem Material in Kontakt gebracht werden, welches den Quellstoff enthält. Dies kann z.B. eine PVB-Folie mit einem hohen Weichmacheranteil wie Triethylenglykol-diethylhexanoat (3G8) sein. Abhängig von den verwendeten Quellchemikalien und der auf dem Hologramm aufgebrachten Schicht die diesen Quellstoff enthält und abgeben kann, kann sich deren Konzentration nach dem Eindiffundieren in der Hologrammschicht abhängig von der Temperatur verändern, da sich das Diffusionsgleichgewicht und das Konzentratrationsgefälle zwischen den beiden Schichten temperaturabhängig einstellt. Mit der Verschiebung des Absorptionspeak verändert sich auch der Wiedergabewinkel für eine bestimmte Wellenlänge, dieser reversible Effekt kann daher als Sensor oder optischer Schalter verwendet werden.

Falls dieser Effekt z.B. innerhalb einer Verbundglasscheibe nicht erwünscht ist, kann vorzugsweise eine Versiegelung z.B. ein UV-Lack auf das Hologramm aufgebracht werden, welche als Schutz- und Sperrschicht vor eindiffundierenden Stoffen dient.

Besonders bevorzugt wird die Verwendung des erfindungsgemäßen Elements für ein Head-up-Display, eine Verbundglasscheibe, eine Datenbrille, ein Lichtleitsystem, ein Spektrometer, ein Detektionssystem, ein Sicherheitselement oder ein Label.

## Beispiele

### Abkürzungsverzeichnis

| | |
|---|---|
| BWG, η | Beugungswirkungsgrad |
| CGI 7460 | Tetrabutylammonium-Tris(3-flourphenyl)hexylborat, SEC LCA 1460, BASF |
| CN 9002 | Aliphatisches Urethan Acrylat |
| Ebecryl 230 | Aliphatisches Urethan Diacrylat |
| NPG | N-Phenylglycin |
| Omnirad 1173 | 2-Hydroxy-2-methyl-1-phenylpropanone |
| PCL-triol | Poly-(caprolacton)-triol, $M_n$ -300 |
| PolyCLO | Capromer PT-05, Polycaprolactone, $M_n$ -540 |
| Safranin-O | 3,7-Diamino-2,8-dimethyl-5-phenyl-phenaziniumchlorid |
| Schwego-Fluor 8038 | ethanolische Lösung eines Fluortensids auf Polyetherbasis von der Fa. Schwegmann |
| SEC LCA 1460 | Tetrabutylammonium-Tris(3-flourphenyl)hexylborat, Boratsalz, Co-Initiator |
| SR 349 | Ethoxyliertes Bisphenol-A-Diacrylat |
| $T_{Peak}$ | Peakwert, Transmission bei der Wellenlänge, welche die Bragg-Bedingung erfüllt |
| $T_{Ref}$ | Referenzwert, Transmission ohne Hologramm |

Die folgenden Beispiele fallen nicht unter den Wortlaut der Ansprüche, werden aber als das Verständnis der Erfindung erleichternd angesehen. Aus dem Stand der Technik ist eine Zusammensetzung gemäß Tabelle 1 bekannt.

Tabelle 1

| **Vergleichsbeispiel VB1** | | | |
|---|---|---|---|
| **Menge[g]** | **Menge[%]** | **Bezeichnung** | **CAS** |
| 91,93 | 91,93 % | SR 349 | 64401-02-1 |
| 0,03 | 0,03 % | Safranin-O | 477-73-6 |
| 0,34 | 0,34 % | CGI 7460 | |
| 3,75 | 3,75 % | Rizinusöl | 8001-79-4 |
| 3,75 | 3,75 % | Palmkernöl | 8023-79-8 |
| 0,2 | 0,20 % | Schwego-Fluor 8038 | - |
| | | | |
| 100 | 100,00 % | | |

Die Zusammensetzung ist aus der EP 1 779 196 B1 bekannt.

## Erfindungsgemäße Beispiele

Tabelle 2

| **Farbstoffkonzentrate FK1** | | | |
|---|---|---|---|
| **Menge[g]** | **Menge[%]** | **Bezeichnung** | **CAS** |
| 19,55 | 65,17% | PolyCLO TMP540 | 37625-56-2 |

(fortgesetzt)

| Farbstoffkonzentrate FK1 | | | |
|---|---|---|---|
| **Menge[g]** | **Menge[%]** | **Bezeichnung** | **CAS** |
| 10,00 | 33,33% | Omnirad 1173 | 7473-98-5 |
| 0,15 | 0,50% | NPG | 103-01-5 |
| 0,30 | 1,00% | Methylenblau | 61-73-4 |
| | | | |
| 30,00 | 100,00% | | |

Tabelle 3

| Farbstoffkonzentrat FK2 | | | |
|---|---|---|---|
| **Menge[g]** | **Menge[%]** | **Bezeichnung** | **CAS** |
| 12,00 | 40,00% | PCL-triol | 37625-56-2 |
| 12,00 | 40,00% | Omnirad 1173 | 7473-98-5 |
| 5,40 | 18,00% | Benzaldehyd | 100-52-7 |
| 0,60 | 2,00% | Methylenblau | 61-73-4 |
| | | | |
| 30,00 | 100,00% | | |

Tabelle 4

| Monomerhaltige Mischung MM1 | | | |
|---|---|---|---|
| **Menge[g]** | **Menge[%]** | **Bezeichnung** | **CAS** |
| 287,5 | 57,16% | SR 349 | 64401-02-1 |
| 212,5 | 42,25% | Ebecryl 230 | |
| 3 | 0,60% | SEC LCA 1460 | |
| | | | |
| 503,00 | 100,00% | | |

Tabelle 5

| Monomerhaltige Mischung MM2 | | | |
|---|---|---|---|
| **Menge[g]** | **Menge[%]** | **Bezeichnung** | **CAS** |
| 23 | 57,07% | SR 349 | 64401-02-1 |
| 17 | 42,185% | CN 9002 | |
| 0,3 | 0,74% | SEC LCA 1460 | |
| | | | |
| 40,30 | 100,00% | | |

Für die Belichtungen der Proben A, B und C wurden folgende photopolymerisierbaren Zusammensetzungen aus den oben aufgeführten monomerhaltigen Mischungen und Farbstoffkonzentraten erstellt. Als Vergleichsbeispiel wurde die bekannte Rezeptur aus Tabelle 1 ohne das Safranin-O verwendet. Anstatt Safranin-O wurde der Mischung A das Farbkonzentrat FK2 mit Methylenblau hinzugegeben.

Die Proben D, E und F wurden nur mit UV-Licht gehärtet. Deswegen wurde dort anstatt des Farbstoffkonzentrates nur der UV-Photoinitiator Omnirad 1173 zugegeben.

Tabelle 6

| Photopolymerisierbare Zusammensetzung A | | | |
|---|---|---|---|
| **Menge[g]** | **Menge[%]** | **Komponente** | **Name** |
| 5 | 97,09% | VB1 ohne Safranin-O | Monomerhaltige Mischung aus dem Vergleichsbeispiel |
| 0,15 | 2,91% | FK2 | Farbstoffkonzentrat |
| | | | |
| 5,15 | 100,00% | | |

Tabelle 7

| Photopolymerisierbare Zusammensetzung B | | | |
|---|---|---|---|
| Menge[g] | Menge[%] | Komponente | Name |
| 5 | 97,09% | MM1 | Monomerhaltige Mischung |
| 0,15 | 2,91% | FK1 | Farbstoffkonzentrat |
| | | | |
| 5,15 | 100,00% | | |

Tabelle 8

| Photopolymerisierbare Zusammensetzung C | | | |
|---|---|---|---|
| Menge[g] | Menge[%] | Komponente | Name |
| 5 | 97,09% | MM2 | Monomerhaltige Mischung |
| 0,15 | 2,91% | FK2 | Farbstoffkonzentrat |
| | | | |
| 5,15 | 100,00% | | |

Tabelle 9

| Photopolymerisierbare Zusammensetzung D | | | |
|---|---|---|---|
| **Menge[g]** | **Menge[%]** | **Komponente** | **Name** |
| 5 | 97,09% | VB1 ohne Safranin-O | Monomerhaltige Mischung aus dem Vergleichsbeispiel |
| 0,1 | 1,96% | Omnirad 1173 | Photoinitiator |
| | | | |
| 5,1 | 100,00% | | |

Tabelle 10

| Photopolymerisierbare Zusammensetzung E | | | |
|---|---|---|---|
| **Menge[g]** | **Menge[%]** | **Komponente** | **Name** |
| 5 | 97,09% | MM1 | Monomerhaltige Mischung |
| 0,1 | 1,96% | Omnirad 1173 | Photoinitiator |
| | | | |
| 5,1 | 100,00% | | |

Tabelle 11

| Photopolymerisierbare Zusammensetzung F | | | |
|---|---|---|---|
| Menge[g] | Menge[%] | Komponente | Name |
| 5 | 97,09% | MM2 | Monomerhaltige Mischung |
| 0,1 | 1,96% | Omnirad 1173 | Photoinitiator |
| | | | |
| 5,1 | 100,00% | | |

## Belichtungen

Tabelle 12

| Laserbelichtungen | | | | |
|---|---|---|---|---|
| Material | Peak[nm] | BWG[%] | Dicke[μm] | Δn |
| A | 574 | 80 % | 124 | 0,0021 |
| B | 578 | 87 % | 138 | 0,0022 |
| C | 578 | 96 % | 115 | 0,0037 |

Die photopolymerisierbaren Zusammensetzungen A, B und C wurden mit einem Laser mit der Wellenlänge von 577 nm in einem Temperaturbereich von 20°C bis 21°C belichtet. Die photopolymerisierbaren Zusammensetzungen wurden in einem Ofen bei 80°C aufbewahrt und kurz nach dem Auftragen belichtet. Nach der Laserbelichtung und der UV-Härtung wurde mit einem Spektrometer anhand der spektralen Absorptionskurve der Beugungswirkungsgrad (BWG) bestimmt. Die Schichtdicke wurde mit einer digitalen Mikrometer-Bügelmeßschraube gemessen.

Um den belichtungsabhängigen Trübungseffekt zu zeigen, wurden die Proben D, E und F mit unterschiedlich starken UV-Lichtquellen gehärtet. Für die schnelle Härtung wurde wieder die oben beschriebene UV-Brücke verwendet. Obwohl für die Härtung eine wesentlich kürzere Zeit reicht, wurden die Proben 30s lang bestrahlt. Für die langsame Belichtung wurde die Hamamatsu UV-Spot Lichtquelle LC6 verwendet. Das UV-Licht tritt am Ende eines flexiblen Lichtleiters mit der Intensität von 3,5 W/cm$^2$ aus. Die Proben wurden damit 120s lang in einem Abstand von 6cm zur Austrittsöffnung belichtet. Danach wurden sie sicherheitshalber noch einmal 30s lang unter der UV-Brücke nachgehärtet.

Tabelle 13

| UV-Belichtungen | | | | | | |
|---|---|---|---|---|---|---|
| **Material** | **Haze-Wert der langsamen Belichtung** | **Probendicke der langsamen Belichtung [μm]** | **Haze-Wert der schnellen Belichtung** | **Probendicke der schnellen Belichtung [μm]** | **Haze-Differenz** | **Temperatur [°C]** |
| D | 82 % | 948 | 2 % | 936 | 80 % | 26 |
| D | 89 % | 890 | 70 % | 855 | 19 % | 21 |
| E | 80% | 935 | 2% | 928 | 78 % | 21 |
| F | 80% | 950 | 2 % | 889 | 78 % | 21 |

Die photopolymerisierbaren Zusammensetzungen für die UV-Belichtungen wurden bei einer Raumtemperatur von 21°C aufbewahrt. Nur für die erste Belichtung wurde das Vergleichsmaterial D bei 26°C aufbewahrt und verarbeitet. Die zweite Belichtung bei 21°C mit der photopolymerisierbaren Zusammensetzung D hat trotz schneller Belichtung einen hohen Haze-Wert von 70%, weil bei dieser Temperatur schon die flüssige Formulierung milchig ist.

**Belichtungsaufbau**

Der Laserstrahl mit einer gemessenen Leistung von 1,43W wurde mit einem Polygonscanner horizontal aufgeweitet und durch eine Zylinderlinse so gebündelt, dass er eine Belichtungsbreite von 23cm abdeckte. Figur 2 zeigt den schematischen Belichtungsaufbau.

Bezugszeichen in Figur 2:

1 Laser 577nm

2 Spiegel

3 Polygonscanner

4 Zylinderlinse

5 Scanstrahl

6 Scannerspiegel

Die jeweiligen Proben wurden mit Hilfe eines verschiebbaren Spiegels mit dieser Linie abgescannt und belichtet. Die Verfahrgeschwindigkeit wurde auf 9mm/s eingestellt. Der Laserstrahl fiel mit einem Winkel von 22° zum Lot auf die Probenoberfläche.
Die Figur 3 zeigt den Strahlengang.

Bezugszeichen in Figur 3:

1 Scanstrahl 577nm

2 Scannerspiegel

3 Belichtungsrichtung

4 Belichtungswinkel, 22°

5 Substrat, Glas oder Folie

6 Photopolymer (photopolymerisierbare Zusammensetzung)

7 Master, Spiegelblech

Damit ein Reflexionshologramm entsteht wurde das Probenmaterial auf ein Spiegelblech aufgetragen, welches das Laserlicht zurückreflektiert. Durch die Interferenz des auftreffenden mit dem reflektierten Strahl entsteht parallel zur Oberfläche des Spiegels ein Linienmuster aus hellen und dunklen Stellen. Dieses Interferenzmuster wird vom Material in Form einer Brechungsindexmodulation aufgezeichnet und es entsteht ein sogenanntes Lippmann-Bragg-Hologramm.
Bei der Laserbelichtung befindet sich die Photopolymerschicht zwischen den Spiegelblech und einem transparenten Trägermaterial, z.B. eine PET-Folie oder Glas. Für die Beispiele wurden Objektglasträger verwendet. Mit dem Glas wird ein auf dem Spiegelblech aufgetragener Tropfen abgedeckt. Die Schichtdicke ergibt sich durch die Tropfenmenge und der Tropfenausdehnung. Die Größe der kreisförmigen Ausdehnung kann durch den Anpressdruck, der Temperatur und der Verlaufzeit gesteuert werden. Auch Abstandshalter (Spacer) können genutzt werden um eine bestimmte Schichtdicke zu erreichen. Nach der Laserbelichtung wird das Material noch mit UV-Licht gehärtet. Für den ersten Härtungsschritt verwenden wir einen UV-Blitz mit einer Stärke von 3000 WS. Dies reicht aus um danach das Hologramm mit den Träger vom Blech zu entfernen. Damit die Haftung zum Glas gewährleistet ist, sollte dies mit einem Primer vorbehandelt werden.

Für die endgültige Härtung der Probe verwenden wir eine UV-Brücke mit einer Lichtbogenlänge von 70 mm und einer Leistung von 120 W/cm und eine Belichtungszeit von 30s.

**Messaufbau**

Gemessen wurden die Proben mit einem Spektrometer (CAS 140 B von der Fa. Instrument Systems) in Durchlicht. Und zwar bei senkrechter Beleuchtung. Da das Hologramm nur die Wellenlänge reflektiert, welche die Bragg-Bedingung erfüllt, ist in der Spektralkurve an dieser Stelle ein deutlicher Absorptionspeak zu sehen.

Aus dem Peakwert $T_{Peak}$ und einem in der Nähe befindlichen Referenzwert $T_{Ref}$ auf der oberen Grundlinie berechnet sich der Beugungswirkungsgrad (BWG) η wie folgt:

$$\eta = (T_{Ref} - T_{Peak})/T_{Ref}$$

Figur 4 zeigt die Messkurve mit den entsprechenden Meßpunkten der Probe C.

Die Tabellenwerte der Belichtungen (Tab. 12) zeigen, dass alle Proben bei einer Schichtdicke von über 100μm einen hohen Beugungswirkungsgrad von über 80% erreichen. Die Belichtungen der erfindungsgemäßen photopolymerisierbaren Zusammensetzungen B und C erreichen sogar einen höheren Wert als die Vergleichsmischung A.

Die Haze-Werte der UV-Belichtungsproben D, E und F wurden mit einem Hazemeter (haze-gard i von der Fa. BYK) unter der Verwendung einer 4mm Aperturblende nach dem ASTM D 1003 Standardverfahren gemessen. Die Tabellenwerte (Tab. 13) zeigen, dass durch verschieden Belichtungsintensitäten unterschiedliche Trübungen erreicht werden können. Bei einer Schichtstärke von etwa 0,9 mm kann die Differenz mehr als 70% betragen. Die beiden Messungen der Vergleichsprobe D zeigen, dass die Belichtungstemperatur ebenfalls ein Einfluss hat. Im Gegensatz zu den erfindungsgemäßen Zusammensetzungen E und F ist die flüssige Vergleichsmischung D bei 21°C nicht klar.

**Fertigung**

Figur 1 zeigt den schematischen Aufbau einer kompakten Rolle zu Rolle Maschine für die Anfertigung von holographischen Kontaktkopien aus der beanspruchten photopolymerisierbaren Zusammensetzung.

Bezugszeichen in Figur 1:

| | |
|---|---|
| 1 | Vorratsbehälter |
| 2 | Filter und Entgaser |
| 3 | Dosiereinheit |
| 4 | Trägerfolie |
| 5 | Photopolymer (photopolymerisierbare Zusammensetzung) |
| 6 | Trägerfolie mit Hologramm |
| 7 | Folienabwicklung |
| 8 | Laserlicht |
| 9 | Master |
| 10 | UV-Licht |
| 11 | Folienaufwicklung |

## Patentansprüche

1. Photopolymerisierbare Zusammensetzung die durch UV/VIS-Bestrahlung härtbar ist, bestehend aus:

    a) 25 bis 74,9 Gew.-% mindestens eines Monomers M, umfassend mindestens eine ethylenisch ungesättigte Gruppe oder eines Monomergemisches, umfassend mindestens zwei Monomere M, umfassend unterschiedliche ethylenisch ungesättigte Gruppen, wobei das Monomer M ausgewählt ist aus der Gruppe, bestehend aus (Meth)acrylsäurebutylester, (Meth)acrylsäurephenylester, (Meth)acrylsäurebenzylester, (Meth)acrylsäureisobornylester, (Meth)acrylsäurecyclohexylester, (Meth)acrylsäure-2-phenoxyethylester, (Meth)acrylsäure-1H,1H,2H,2H-perfluoroctylester, 2,2,2-Trifluorethyl(meth)acrylat, Heptafluorpropyl(meth)acrylat, 1,1,1,3,3,3-Hexyfluorisopropyl(meth)acrylat, 2,2,3,3-Tetrafluorpropyl(meth)acrylat), 2,2,3,3,4,4,4-Heptafluorbutyl(meth)acrylat, 2,2,3,3,4,4,5,5-Octafluorpentyl(meth)acrylat, Acrylsäure-N,N-diethylaminoethylester, Acrylsäureethoxyethyoxyethylester, Acrylsäure-2-(p-chlorphenoxy)ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, Hydrochinonmonomethacrylat und 2-[β-(N-Carbazolyl)propionyloxy]ethylacrylat, und außerdem ein Bisphenol A diacrylat mit einem Anteil von über 25 Gew.-% enthält, bezogen auf das Gesamtgewicht der Komponente a),
    b) 25 bis 74,9 Gew.-% eines aliphatischen Urethanacrylates oder eines Gemisches aus verschiedenen aliphatischen Urethanacrylaten,
    c) 0,1 bis 10 Gew.-% eines Photoinitiators, der die Polymerisation der Monomere und Urethanacrylate bei der Einwirkung aktinischer Strahlung aktiviert;
    d) 0,01 bis 20 Gew.-% Additive,

    wobei die photopolymerisierbare Zusammensetzung bei einem Standarddruck im Bereich von 15°C bis 150°C flüssig ist.

2. Photopolymerisierbare Zusammensetzung nach Anspruch 1,
wobei der Unterschied zwischen den Brechungsindizes der Komponente a) und der Komponente b) bei 20°C mindestens 0,02 beträgt.

3. Photopolymerisierbare Zusammensetzung nach Anspruch 1 oder 2,
wobei der Photoinitiator einen Farbstoff und als Coinitiator ein Boratsalz enthält.

4. Photopolymerisierbare Zusammensetzung nach einem der Ansprüche 1 bis 3,
wobei der Coinitiator ausgewählt ist aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

5. Photopolymerisierbare Zusammensetzung nach einem der Ansprüche 1 bis 4, wobei die Viskosität der photopolymerisierbaren Zusammensetzung bei 20°C mindestens 2000mPa s beträgt.

6. Photopolymerisierbare Zusammensetzung nach einem der Ansprüche 1 bis 5, wobei die Komponente b) ein aliphatisches Urethanediacrylat Harz oder ein difunktionelles aliphatisches Urethanediacrylat Harz ist.

7. Element, enthaltend eine Komponente, die erhältlich ist durch die Einwirkung von UV/VIS-Strahlung, vorzugsweise aktinischer UV/VIS-Strahlung auf die photopolymerisierbare Zusammensetzung nach einem der Ansprüche 1 bis 6.

8. Element nach Anspruch 7, umfassend eine Komponente, die transparente und/oder transluzente Bereiche aufweist.

9. Element nach Anspruch 7 oder 8, umfassend ein Hologramm, das erhältlich ist durch die Einwirkung einer holographischen Information tragenden, modulierten Strahlung auf die photopolymerisierbare Zusammensetzung nach einem der Ansprüche 1 bis 6.

10. Verwendung des Elements nach einem der Ansprüche 7 bis 9, als Folie, Linse, Gitter, Prisma, Spiegel, Strahlteiler, Diffusor, Oberflächenrelief, optischen Schalter oder Sensor.

11. Verwendung des Elements nach einem der Ansprüche 7 bis 9 für ein Head-up-Display, eine Verbundglasscheibe, eine Datenbrille, ein Lichtleitsystem, ein Spektrometer, ein Detektionssystem, ein Sicherheitselement oder ein Label.

**12.** Verfahren zur Herstellung eines Elements nach einem der Ansprüche 7 bis 9 oder der photopolymerisierbaren Zusammensetzung nach einem der Ansprüche 1 bis 6 bei denen das Element oder die Zusammensetzung einer Temperatur von mehr als 100°C und einem Druck von mehr als 2 bar ausgesetzt ist.

**13.** Verfahren zur Bildung eines lichtbeständigen Hologramms in einer photopolymerisierbaren Schicht auf einer Substratoberfläche oder Kopiervorlage, umfassend die Einwirkung einer eine holographische Information tragenden, modulierten Strahlung auf eine Schicht einer photopolymerisierbaren Zusammensetzung nach einem der Ansprüche 1 bis 6.

**14.** Verfahren bei dem die photopolymerisierbare Zusammensetzung nach einem der Ansprüche 1 bis 6 innerhalb einer Minute aufgetragen und belichtet wird.

## Claims

**1.** A photopolymerisable composition curable by UV/VIS irradiation consisting of:

a) 25 to 74.9% by weight of at least one monomer M comprising at least one ethylenically unsaturated group or of a monomer mixture comprising at least two monomers M comprising different ethylenically unsaturated groups, wherein monomer M is selected from the group consisting of (meth)acrylic acid butyl ester, (meth)acrylic acid phenyl ester, (meth)acrylic acid benzyl ester, (meth)acrylic acid isobornyl ester, (meth)acrylic acid cyclohexyl ester, (meth)acrylic acid 2-phenoxyethyl ester, (meth)acrylic acid 1H,1H,2H,2H-perfluorooctyl ester, 2,2,2-trifluoroethyl (meth)acrylate, heptafluoropropyl (meth)acrylate, 1,1,1,3,3,3-hexyfluoroisopropyl (meth)acrylate, 2,2,3,3-tetrafluoropropyl (meth)acrylate), 2,2,3,3,4,4,4-heptafluorobutyl (meth)acrylate, 2,2,3,3,4,4,5,5-octafluoropentyl (meth)acrylate, acrylic acid N,N-diethylaminoethyl ester, acrylic acid ethoxyethoxyethyl ester, acrylic acid 2-(p-chlorophe-noxy)ethyl ester, p-chlorophenyl acrylate, 2-phenylethyl (meth)acrylate, pentachlorophenyl acrylate, phenyl acrylate, p-chlorostyrene, n-vinylcarbazole, 1-vinyl-2-pyrrolidone, 2-chlorostyrene, 2-bromostyrene, methoxystyrene, phenol ethoxylate acrylate, 2-(p-chlorophenoxy)ethyl acrylate, hydroquinone monomethacrylate, and 2-[β-(N-carbazolyl)pro-pionyloxy]ethyl acrylate, and also contains bisphenol A diacrylate in an amount exceeding 25% by weight, based on the total weight of component a),
b) 25 to 74.9% by weight of an aliphatic urethane acrylate or a mixture of different aliphatic urethane acrylates,
c) 0.1 to 10% by weight of a photoinitiator which activates the polymerisation of the monomers and urethane acrylates upon exposure to actinic radiation;
d) 0.01 to 20% by weight of additives;

wherein the photopolymerisable composition is liquid at a standard pressure in the range of 15°C to 150°C.

**2.** The photopolymerisable composition according to claim 1,
wherein the difference between the refractive indices of component a) and component b) at 20°C is at least 0.02.

**3.** The photopolymerisable composition according to claim 1 or 2,
wherein the photoinitiator contains a dye and as co-initiator a borate salt.

**4.** The photopolymerisable composition according to any one of claims 1 to 3,
wherein the co-initiator is selected from the group consisting of tetrabutylammonium tetrahexylborate, tetrabutylammonium triphenylhexylborate, tetrabutylammonium tris-(3-fluorophenyl)-hexylborate and tetrabutylammonium tris-(3-chloro-4-methylphenyl)-hexylborate or mixtures thereof.

**5.** The photopolymerisable composition according to any one of claims 1 to 4,
wherein the viscosity of the photopolymerisable composition at 20°C is at least 2000mPa·s.

**6.** The photopolymerisable composition according to any one of claims 1 to 5,
wherein component b) is an aliphatic urethanediacrylate resin or a difunctional aliphatic urethanediacrylate resin.

**7.** An element comprising a component obtainable by exposure of the photopolymerisable composition according to any one of claims 1 to 6 to UV/VIS radiation, preferably actinic UV/VIS radiation.

**8.** The element of claim 7, comprising a component having transparent and/or translucent regions.

9. The element according to claim 7 or 8, comprising a hologram obtainable by exposing the photopolymerisable composition according to any one of claims 1 to 6 to modulated radiation carrying holographic information.

10. Use of the element according to any one of claims 7 to 9, as a film, lens, grating, prism, mirror, beam splitter, diffuser, surface relief, optical switch or sensor.

11. Use of the element according to any one of claims 7 to 9 for a head-up display, a laminated glass panes, data glasses, a light guidance system, a spectrometer, a detection system, a security element or a label.

12. A process for the preparation of an element according to any one of claims 7 to 9 or the photopolymerisable composition according to any one of claims 1 to 6 in which the element or composition is subjected to a temperature of more than 100°C and a pressure of more than 2 bar.

13. A method of forming a light stable hologram in a photopolymerisable layer on a substrate surface or copy master, comprising exposing a layer of a photopolymerisable composition according to any one of claims 1 to 6 to modulated radiation carrying holographic information.

14. A process in which the photopolymerisable composition of any one of claims 1 to 6 is applied and exposed within one minute.

**Revendications**

1. Composition photopolymérisable qui peut être durcie par rayonnement UV-visible, qui consiste en :

   a) 25 à 74,9 % en poids d'au moins un monomère M, comprenant au moins un groupe à insaturation éthylénique ou un mélange de monomères, comprenant au moins deux monomères M, comprenant différents groupes à insaturation éthylénique, le monomère M étant choisi parmi le groupe constitué par l'ester butylique de l'acide (méth)acrylique, l'ester phénylique de l'acide (méth)acrylique, l'ester benzylique de l'acide (méth)acrylique, l'ester isobornylique de l'acide (méth)acrylique, l'ester cyclohexylique de l'acide (méth)acrylique, l'ester 2-phénoxyéthylique de l'acide (méth)acrylique, l'ester 1H,1H,2H,2H-perfluorooctylique de l'acide (méth)acrylique, le (méth)acrylate de 2,2,2-trifluoroéthyle, méthacrylate d'heptafluoropropyle, méthacrylate de 1,1,1,3,3,3-hexyfluoroisopropyle, méthacrylate de 2,2,3,3-tétrafluoropropyle), (méth)acrylate de 2,2,3,3,4,4,4-heptafluorobutyle, (méth)acrylate de 2,2,3,3,4,4,5,5-octafluoropentyle, ester N,N-diéthylaminoéthylique de l'acide acrylique, ester éthoxyéthyloxyéthylique de l'acide acrylique, ester 2-(p-chlorophénoxy)éthylique de l'acide acrylique, acrylate de p-chlorophényle, (méth)acrylate de 2-phényléthyle, acrylate de pentachlorophényle, acrylate de phényle, p-chlorostyrène, n-vinylcarbazole, 1-vinyl-2-pyrrolidone, 2-chlorostyrène, 2-bromostyrène, méthoxystyrène, acrylate de phénoléthoxylate, acrylate de 2-(p-chlorophénoxy)éthyle, monométhacrylate d'hydroquinone et acrylate de 2-[β-(N-carbazolyl)propionyloxy]éthyle, et en outre un diacrylate de bisphénol A dans une proportion supérieure à 25 % en poids par rapport au poids total du composant a),
   b) 25 à 74,9 % en poids d'un uréthane-acrylate aliphatique ou d'un mélange de différents uréthanes-acrylates aliphatiques,
   c) 0,1 à 10 % en poids d'un photoinitiateur qui active la polymérisation des monomères et des uréthanes-acrylates sous l'action d'un rayonnement actinique ;
   d) 0,01 à 20 % en poids d'additives ;

   dans laquelle la composition photopolymérisable est liquide à une pression normale dans la plage de 15 °C à 150 °C.

2. Composition photopolymérisable selon la revendication 1,
   dans laquelle la différence entre les indices de réfraction du composant a) et du composant b) à 20 °C est d'au moins 0,02.

3. Composition photopolymérisable selon la revendication 1 ou 2,
   dans laquelle the photoinitiateur contient un colorant et, comme coinitiateur un sel de borate.

4. Composition photopolymérisable selon l'une des revendications 1 à 3,
   dans laquelle le coinitiateur est choisi dans le groupe constitué de tétrahexylborate de tétrabutylammonium, triphénylhexylborate de tétrabutylammonium, tris-(3-fluorophényl)-hexylborate de tétrabutylammonium et tris-(3-chloro-4-méthylphényl)-hexylborate de tétrabutylammonium ou de mélanges de ceux-ci.

5. Composition photopolymérisable selon l'une des revendications 1 à 4, dans laquelle la viscosité de la composition photopolymérisable à 20 °C est d'au moins 2 000 mPa s.

6. Composition photopolymérisable selon l'une des revendications 1 à 5, dans laquelle le composant b) est une résine uréthane-diacrylate aliphatique ou une résine uréthane-diacrylate aliphatique bifonctionnelle.

7. Élément contenant un composant qui peut être obtenu par l'action d'un rayonnement UV-visible, de préférence d'un rayonnement UV-visible actinique, sur la composition photopolymérisable selon l'une des revendications 1 à 6.

8. Élément selon la revendication 7, comprenant un composant qui présente des régions transparentes et/ou translucides.

9. Élément selon la revendication 7 ou 8, comprenant un hologramme qui peut être obtenu par l'action d'un rayonnement modulé portant des informations holographiques sur la composition photopolymérisable selon l'une des revendications 1 à 6.

10. Utilisation de l'élément selon l'une des revendications 7 à 9, en tant que feuille, lentille, grille, prisme, miroir, séparateur de faisceau, diffuseur, relief de surface, commutateur optique ou capteur.

11. Utilisation de l'élément selon l'une des revendications 7 à 9 pour un affichage tête haute, une vitre en verre feuilleté, des lunettes intelligentes, un système de guidage de lumière, un spectromètre, un système de détection, un élément de sécurité ou une étiquette.

12. Procédé permettant la production d'un élément selon l'une des revendications 7 à 9 ou de la composition photopolymérisable selon l'une des revendications 1 à 6, dans lequel l'élément ou la composition est exposé à une température supérieure à 100 °C et à une pression supérieure à 2 bar.

13. Procédé permettant la formation d'un hologramme résistant à la lumière dans une couche photopolymérisable sur une surface de substrat ou une copie de référence, comprenant l'action d'un rayonnement modulé portant des informations holographiques sur une couche d'une composition photopolymérisable selon l'une des revendications 1 à 6.

14. Procédé dans lequel la composition photopolymérisable selon l'une des revendications 1 à 6 est appliquée et irradiée en une minute.

Figur 1:

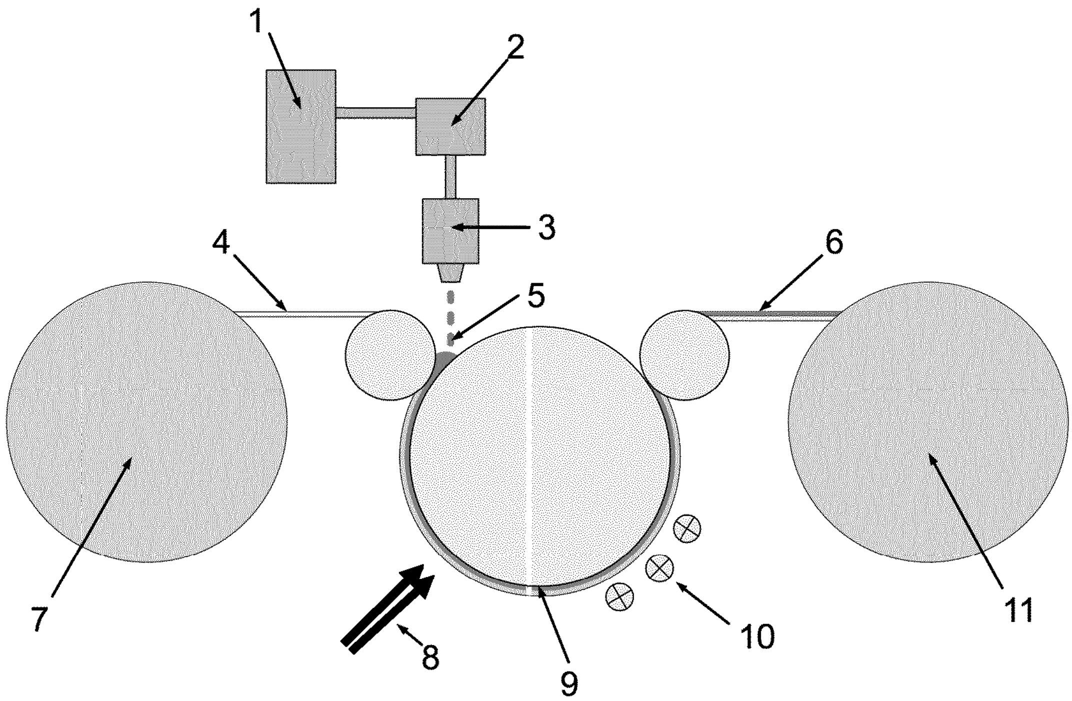

**Figur 2:**

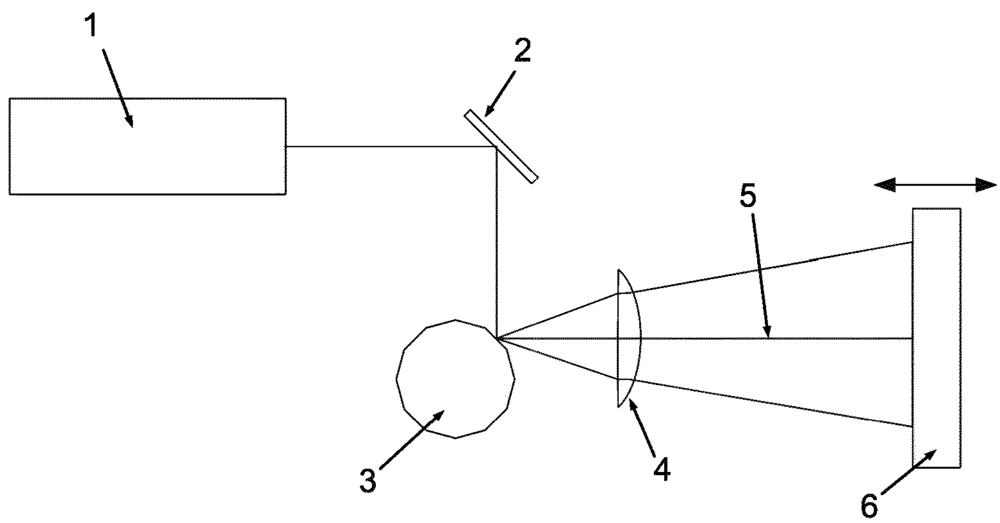

Figur 3:

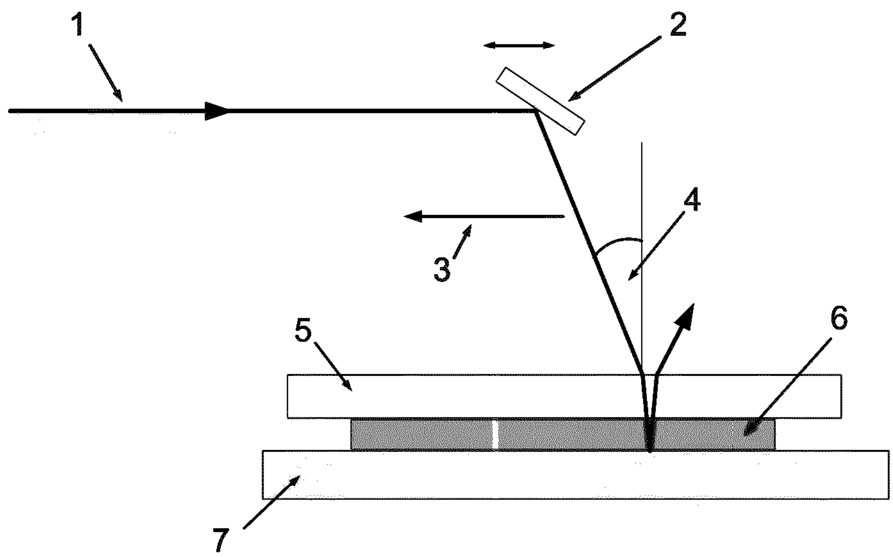

**Figur 4:**

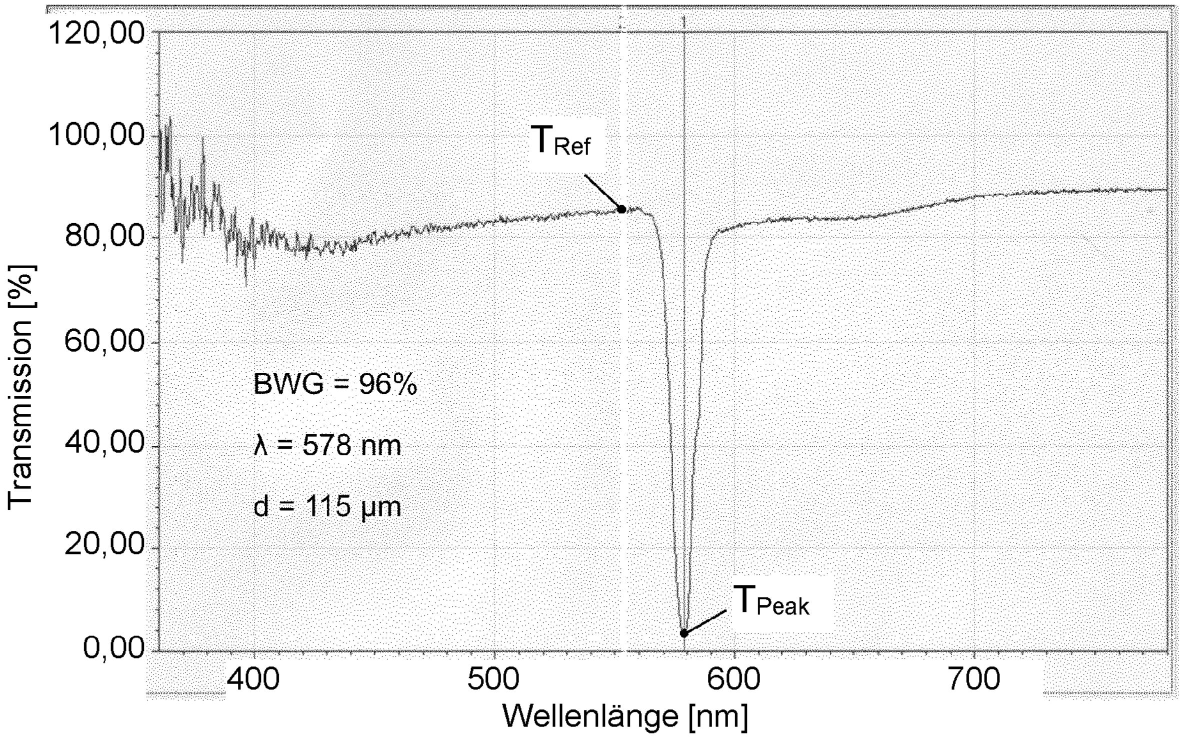
120,00
100,00
80,00
60,00
40,00
20,00
0,00
Transmission [%]
400
500
600
700
Wellenlänge [nm]
TRef
TPeak
BWG = 96%
λ = 578 nm
d = 115 µm

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 0324480 A2
- US 4942112 A
- DE 69032682 T2
- DE 68905610 T2
- US 5759721 A
- EP 1510862 A2
- US 200505891 A1
- EP 123151 A1
- EP 211615 A2
- US 20050068594 A1
- WO 2010091795 A1
- WO 2003036389 A1
- US 2002142227 A1
- US 3993485 A
- EP 2372454 A1
- EP 2219073 A1
- EP 1779196 B1
- WO 03033583 A1
- DE 1644798 A
- DE 2115373 A
- DE 2737406 A
- US 2760663 A
- US 2850445 A
- US 2875047 A
- US 3097096 A
- US 3074974 A
- US 3097097 A
- US 3145104 A
- US 3579339 A
- US 3427161 A
- US 3479185 A
- US 3549367 A
- US 4311783 A
- US 4622286 A
- US 3784557 A
- US 4341860 A
- US 3554753 A
- US 3563750 A
- US 3563751 A
- US 3647467 A
- US 3652275 A
- US 4162162 A
- US 4268667 A
- US 4454218 A
- US 4535052 A
- US 4565769 A
- WO 2012062655 A2
- US 3854950 A
- US 4168982 A
- US 3390996 A
- US 4326010 A
- DE 60216490 T2
- US 5017406 A
- DE 60030223 T2


### In der Beschreibung aufgeführte Nicht-Patentliteratur


- **HOWARD M. SMITH**. Principles of Holography. Wiley, 1969
- **FRED UNTERSEHER et al.** Holography Handbook: Making Holograms the Easy Way. Ross Books, 1982
- **GRAHAM SAXBY**. Practical Holography. Inst, of Physics Pub., 2004
- **S. M. SCHULTZ et al.** Volume grating preferential-order focusing waveguide coupler. *Opt. Lett.*, December 1999, vol. 24, 1708-1710
- **N. SMIRNOVA**. *Optics in Information Systems*, February 2004, 9
- **H. KOGELNIK**. *The Bell System Technical Journal*, November 1969, vol. 48 (9), 2909-2947
- **TIMPE, H.J.** ; **S. NEUENFELD**. Dyes in photoinitiator systems. *Kontakte*, 1990, 28-35
- **JAKUBIAK, J.** ; **J.F. RABEK**. Photoinitiators for visible light polymisation. *Polimery (Warschau)*, 1999, vol. 44, 447-461
- Dye Sensitized Photopolymerization. **D.F: EATON**. Adv. in Photochemistry. Wiley-Interscience, 1986, vol. 13, 427-487
- *CHEMICAL ABSTRACTS*, 64401-02-1
- *CHEMICAL ABSTRACTS*, 477-73-6
- *CHEMICAL ABSTRACTS*, 8001-79-4
- *CHEMICAL ABSTRACTS*, 8023-79-8
- *CHEMICAL ABSTRACTS*, 37625-56-2
- *CHEMICAL ABSTRACTS*, 7473-98-5
- *CHEMICAL ABSTRACTS*, 103-01-5
- *CHEMICAL ABSTRACTS*, 61-73-4
- *CHEMICAL ABSTRACTS*, 100-52-7